(19) Europäisches Patentamt
European Patent Office
Office européen des brevets

(11) **EP 4 590 014 A1**

(12) **EUROPEAN PATENT APPLICATION**
published in accordance with Art. 153(4) EPC

(43) Date of publication:
**23.07.2025 Bulletin 2025/30**

(21) Application number: **23890649.9**

(22) Date of filing: **06.11.2023**

(51) International Patent Classification (IPC):
**H04W 24/02** $^{(2009.01)}$

(52) Cooperative Patent Classification (CPC):
**H04L 25/49; H04W 24/02**

(86) International application number:
**PCT/CN2023/129949**

(87) International publication number:
**WO 2024/104213 (23.05.2024 Gazette 2024/21)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **14.11.2022 CN 202211422272**

(71) Applicant: **Huawei Technologies Co., Ltd.
Shenzhen, Guangdong 518129 (CN)**

(72) Inventors:
- **LIU, Fengwei
  Shenzhen, Guangdong 518129 (CN)**
- **PENG, Zhongchong
  Shenzhen, Guangdong 518129 (CN)**
- **CHEN, Lei
  Shenzhen, Guangdong 518129 (CN)**

(74) Representative: **Pfenning, Meinig & Partner mbB
Patent- und Rechtsanwälte
Theresienhöhe 11a
80339 München (DE)**

(54) **COMMUNICATION METHOD AND RELATED DEVICE**

(57) Embodiments of this application provide a communication method and a related apparatus, so that a first communication apparatus reports first performance indicator information to a second communication apparatus, thereby helping the second communication apparatus determine a nonlinear compensation status of first coefficient information for a power amplifier. This helps the second communication apparatus determine appropriate transmit power for the power amplifier, and improves linearity of a signal output by the second communication apparatus, thereby improving performance of the second communication apparatus. The method in embodiments of this application includes: A first communication apparatus receives a first signal from a second communication apparatus, where the first signal is a signal obtained by performing nonlinear compensation based on first coefficient information. The first communication apparatus sends first performance indicator information to the second communication apparatus, where the first performance indicator information is determined based on a performance indicator of the first signal.

FIG. 10

**Description**

This application claims priority to Chinese Patent Application No. 202211422272.1, filed with the China National Intellectual Property Administration on November 14, 2022 and entitled "COMMUNICATION METHOD AND RELATED APPARATUS", which is incorporated herein by reference in its entirety.

**TECHNICAL FIELD**

This application relates to the field of communication technologies, and in particular, to a communication method and a related apparatus.

**BACKGROUND**

A power amplifier (power amplifier, PA) can amplify a low-power signal generated by a network device or a terminal device to a power level that can be used for long-distance transmission, to implement long-distance communication. Therefore, the PA is a core component of a wireless communication device. When the PA amplifies power of a signal, the PA causes nonlinear distortion, deteriorating a performance indicator of a transmitted signal. For example, the nonlinear distortion caused by the PA may result in performance degradation of an error vector magnitude and an adjacent channel leakage ratio of the transmitted signal. Linearity of the PA and efficiency of the PA are mutually contradictory. Lower power of a signal entering the PA indicates better linearity of a signal processed by the PA (also referred to as a signal after the PA), but lower efficiency of the PA. Higher power of a signal entering the PA indicates poorer linearity of a signal after the PA, but higher efficiency of the PA. Therefore, it is important to improve efficiency of the PA without deteriorating linearity of the signal.

A digital predistortion (digital predistortion, DPD) technology is an effective means to improve linearity of a signal output by the PA. Before a signal passes through the PA, DPD processing is first performed on the signal, and then the signal passes through the PA, so that linearity of the output signal is improved. Specifically, the network device may send a measurement signal to the terminal device. The terminal device feeds back a DPD coefficient based on the measurement signal. Then, the network device performs DPD processing on the signal based on the DPD coefficient before the signal passes through the PA, so that linearity of the output signal is improved.

However, the measurement signal received by the terminal device may be affected by a non-ideal channel factor, interference, noise, or the like, resulting in unstable reliability of the DPD coefficient calculated by the terminal device. For example, when the terminal device suffers burst interference, there is a relatively large error in the calculated DPD coefficient. Consequently, quality of the signal output by the network device cannot be effectively improved, or even quality of the signal output by the network device deteriorates. Therefore, performance improvement of the network device is limited, or even performance of the network device may deteriorate in the foregoing solution. Therefore, how to better compensate for the nonlinear distortion caused by the PA to improve performance of the network device is a problem worth considering.

**SUMMARY**

This application provides a communication method and a related apparatus, so that a first communication apparatus reports first performance indicator information to a second communication apparatus, thereby helping the second communication apparatus determine a nonlinear compensation status of first coefficient information for an equivalent PA.

A first aspect of this application provides a communication method, including:

A first communication apparatus receives a first signal from a second communication apparatus, where the first signal is a signal obtained by performing nonlinear compensation based on first coefficient information. The first communication apparatus sends first performance indicator information to the second communication apparatus, where the first performance indicator information is determined based on a performance indicator of the first signal.

In the foregoing technical solution, the first communication apparatus may report the first performance indicator information to the second communication apparatus, so that the second communication apparatus determines the performance indicator of the first signal. The first signal is a signal obtained by performing nonlinear compensation based on the first coefficient information, so that the second communication apparatus determines a nonlinear compensation status of the first coefficient information for an equivalent PA and a benefit brought by the first coefficient information to performance of the second communication apparatus. In this way, the second communication apparatus can accurately determine transmit power or a backoff value of the equivalent PA, to implement higher transmit power or better signal sending quality, improve linearity of a signal output by the second communication apparatus, and finally improve a coverage area, a capacity, and the like of the second communication apparatus. This helps avoid problems such as performance deterioration of the second communication apparatus caused by improper coefficient information used by a network device. It can be learned that the second communication apparatus processes the signal by using the first coefficient information, and then transmits the signal by using the PA at relatively high power. This can improve a signal coverage capability of the second communication apparatus, improve efficiency of the PA, and reduce power consumption of the PA.

A second aspect of this application provides a communication method, including:

A second communication apparatus sends a first signal to a first communication apparatus, where the first signal is a signal obtained by performing nonlinear compensation based on first coefficient information. The second communication apparatus receives first performance indicator information from the first communication apparatus, where the first performance indicator information is determined based on a performance indicator of the first signal.

In the foregoing technical solution, the second communication apparatus receives the first performance indicator information from the first communication apparatus, where the first performance indicator information is determined based on the performance indicator of the first signal. The first signal is a signal obtained by performing nonlinear compensation based on the first coefficient information, so that the second communication apparatus determines a nonlinear compensation status of the first coefficient information for a PA and a benefit brought by the first coefficient information to performance of the second communication apparatus. In this way, the second communication apparatus can accurately determine transmit power or a backoff value of the PA, to implement higher transmit power or better signal sending quality, improve linearity of a signal output by the second communication apparatus, and finally improve a coverage area, a capacity, and the like of the second communication apparatus. This helps avoid problems such as performance deterioration of the second communication apparatus caused by improper coefficient information used by a network device. It can be learned that the second communication apparatus processes the signal by using the first coefficient information, and then transmits the signal by using the PA at relatively high power. This can improve a signal coverage capability of the second communication apparatus, improve efficiency of the PA, and reduce power consumption of the PA.

Based on the first aspect, in a possible implementation, the first communication apparatus determines the performance indicator of the first signal. This helps determine the first performance indicator information.

Based on the first aspect or the second aspect, in a possible implementation, the performance indicator of the first signal includes at least one of the following: an error vector magnitude (error vector magnitude, EVM), a signal to interference plus noise ratio (signal to interference noise ratio, SINR), a signal-to-noise ratio (signal-to-noise ratio, SNR), a supported modulation and coding scheme (modulation and coding scheme, MCS), a channel quality indicator (channel quality indicator, CQI), a supported highest modulation order, a mean squared error (mean squared error, MSE), a normalized mean squared error (normalization mean squared error, NMSE), or an adjacent channel leakage ratio (adjacent channel leakage ratio, ACLR) of the first signal.

In this implementation, some possible forms of the performance indicator of the first signal are shown, so that the first communication apparatus determines the performance indicator of the first signal.

Based on the first aspect or the second aspect, in a possible implementation, the first performance indicator information includes the performance indicator of the first signal.

In this implementation, the first communication apparatus may report the performance indicator of the first signal to the second communication apparatus, so that the second communication apparatus determines a nonlinear compensation status for a PA and a benefit brought by the first coefficient information to performance of a network device. In this way, the second communication apparatus can accurately determine transmit power or a backoff value of the PA, to implement higher transmit power or better signal sending quality, improve linearity of a signal output by the second communication apparatus, and finally improve a coverage area, a capacity, and the like of the second communication apparatus.

Based on the first aspect or the second aspect, in a possible implementation, the first performance indicator information is determined based on the performance indicator of the first signal and a performance indicator of a second signal, and the second signal is a signal that is received by the first communication apparatus from the second communication apparatus and on which nonlinear compensation is not performed.

In this implementation, the first performance indicator may be determined together with reference to the performance indicator of the second signal before the nonlinear compensation and the performance indicator of the first signal after the nonlinear compensation, so that the first performance indicator information can be used to represent a value of a benefit brought by performing nonlinear compensation on the PA by using the first coefficient information. In this way, the second communication apparatus can set appropriate transmit power for the PA, to implement higher transmit power or better signal sending quality, improve linearity of a signal output by the second communication apparatus, and finally improve a coverage area, a capacity, and the like of the second communication apparatus.

Based on the first aspect or the second aspect, in a possible implementation, the first performance indicator information includes: the performance indicator of the first signal and the performance indicator of the second signal; or the first performance indicator information includes: the performance indicator of the first signal and a variation between the performance indicator of the first signal and the performance indicator of the second signal; or the first performance indicator information includes: the performance indicator of the second signal and a variation between the performance indicator of the first signal and the performance indicator of the second signal.

In this implementation, some possible content included in the first performance indicator information is shown, so that the second communication apparatus determines the performance indicator of the second signal before the nonlinear compensation and the performance indicator of the first signal after the nonlinear compensation. In this way, the second communication apparatus can determine a value of a benefit brought by performing nonlinear compensation on the PA by using the first coefficient information. In this way, the second communication apparatus can set appropriate transmit power for the PA,

Based on the first aspect or the second aspect, in a possible implementation, the variation between the performance indicator of the first signal and the performance indicator of the second signal includes at least one of the following: a variation between the error vector magnitude of the first signal and an error vector magnitude of the second signal; a variation between the signal-to-noise ratio of the first signal and a signal-to-noise ratio of the second signal; a variation between the channel quality indicator of the first signal and a channel quality indicator of the second signal; a variation between the mean squared error of the first signal and a mean squared error of the second signal; or a variation between the normalized mean squared error of the first signal and a normalized mean squared error of the second signal.

In this implementation, some possible forms of the variation between the performance indicator of the first signal and the performance indicator of the second signal are shown. Therefore, the second communication apparatus may determine a variation of each performance indicator of the second signal. In this way, the second communication apparatus can determine a value of a benefit brought by performing nonlinear compensation on the PA by using the first coefficient information.

Based on the first aspect, in a possible implementation, before the first communication apparatus receives the first signal from the second communication apparatus, the method further includes: The first communication apparatus receives indication information from the second communication apparatus.

The indication information indicates time-frequency resource information of the first signal and time-frequency resource information of the second signal, the time-frequency resource information of the first signal indicates location information of a time-frequency resource used by the second communication apparatus to send the first signal, and the time-frequency resource information of the second signal indicates location information of a time-frequency resource used by the second communication apparatus to send the second signal. In this implementation, the first communication apparatus determines the time-frequency resource of the first signal, so that the first communication apparatus receives the first signal.

Based on the second aspect, in a possible implementation, before the second communication apparatus sends the first signal to the first communication apparatus, the method further includes: The second communication apparatus sends indication information to the first communication apparatus. The indication information indicates time-frequency resource information of the first signal and time-frequency resource information of the second signal, the time-frequency resource information of the first signal indicates location information of a time-frequency resource used by the second communication apparatus to send the first signal, and the time-frequency resource information of the second signal indicates location information of a time-frequency resource used by the second communication apparatus to send the second signal. In this way, the first communication apparatus can receive the first signal.

Based on the first aspect, in a possible implementation, the method further includes: The first communication apparatus sends, to the second communication apparatus, first time-frequency resource information associated with the first performance indicator information, where the first time-frequency resource information includes location information of a first time-frequency resource used by the first communication apparatus to receive the first signal, and the first performance indicator information is determined by the first communication apparatus based on the first signal received by the first communication apparatus on the first time-frequency resource.

In this implementation, the first communication apparatus may send the first time-frequency resource information to the second communication apparatus, so that the second communication apparatus determines a performance indicator of a signal based on which the first performance indicator information is determined.

Based on the second aspect, in a possible implementation, the method further includes: The second communication apparatus receives, from the first communication apparatus, first time-frequency resource information associated with the first performance indicator information, where the first time-frequency resource information includes location information of a first time-frequency resource used by the first communication apparatus to receive the first signal, and the first performance indicator information is determined by the first communication apparatus based on the first signal received by the first communication apparatus on the first time-frequency resource. In this implementation, the second communication apparatus receives, from the first communication apparatus, the first time-frequency resource information associated with the first performance indicator information, so that the second communication apparatus determines a performance indicator of a signal based on which the first performance indicator information is determined.

Based on the first aspect or the second aspect, in a possible implementation, the first time-frequency resource information further includes location information of a second time-frequency resource used by the first communication apparatus to receive the second signal, and the first performance indicator information is determined by the first communication apparatus based on the first signal received by the first communication apparatus on the first time-frequency resource and the second signal received by the first communication apparatus on the second time-frequency resource.

In this implementation, the first time-frequency resource information further includes the location information of the second time-frequency resource used for the second signal, so that the second communication apparatus determines a performance indicator of a signal based on which the first performance indicator information is determined.

Based on the first aspect, in a possible implementation, before the first communication apparatus receives the first signal from the second communication apparatus, the method further includes: The first communication apparatus receives the second signal from the second communication apparatus, where the second signal is a signal on which nonlinear compensation is not performed. The first communication apparatus sends the first coefficient information to the second communication apparatus, where the first coefficient information is determined based on the second signal.

In this implementation, the first communication apparatus may determine the first coefficient information with reference to the second signal on which nonlinear compensation is not performed, and report the first coefficient information to the second communication apparatus. In this way, the second communication apparatus can perform nonlinear compensation on the first signal by using the first coefficient information.

Based on the second aspect, in a possible implementation, before the second communication apparatus sends the first signal to the first communication apparatus, the method further includes: The second communication apparatus sends the second signal to the first communication apparatus, where the second signal is a signal on which nonlinear compensation is not performed. The second communication apparatus receives the first coefficient information from the first communication apparatus, where the first coefficient information is determined by the first communication apparatus based on the second signal. In this implementation, the second communication apparatus may send, to the first communication apparatus, a signal on which nonlinear compensation is not performed, so that the first communication apparatus obtains the first coefficient information, and reports the first coefficient information to the second communication apparatus.

Based on the second aspect, in a possible implementation, before the second communication apparatus sends the first signal to the first communication apparatus, the method further includes: The second communication apparatus sends a third signal to a third communication apparatus, where the third signal is a signal on which nonlinear compensation is not performed. The second communication apparatus receives the first coefficient information from the third communication apparatus, where the first coefficient information is determined by the third communication apparatus based on the third signal.

In this implementation, the second communication apparatus may obtain the first coefficient information from the third communication apparatus, and obtain the first performance indicator information from the first communication apparatus. In this way, the second communication apparatus can determine a nonlinear compensation status for the first coefficient information, and determine applicability of the first coefficient information to different channels.

Based on the first aspect or the second aspect, in a possible implementation, the first coefficient information includes any one of the following: information about a predistortion coefficient or information about an equivalent PA coefficient.

Based on the first aspect, in a possible implementation, before the first communication apparatus sends the first performance indicator information to the second communication apparatus, the method further includes: The first communication apparatus receives first configuration information sent by the second communication apparatus, where the first configuration information indicates the first communication apparatus to report a reporting configuration of the first performance indicator information. That the first communication apparatus sends first performance indicator information to the second communication apparatus includes: The first communication apparatus sends the first performance indicator information to the second communication apparatus based on the reporting configuration. In this implementation, the first communication apparatus may send the first performance indicator information to the second communication apparatus based on the reporting configuration configured by the second communication apparatus. In this way, the second communication apparatus can obtain a corresponding performance indicator.

Based on the second aspect, in a possible implementation, the method further includes: The second communication apparatus sends first configuration information to the first communication apparatus, where the first configuration information indicates the first communication apparatus to report a reporting configuration of the first performance indicator information. Therefore, the first communication apparatus may send the first performance indicator information to the second communication apparatus based on the reporting configuration configured by the second communication apparatus. In this way, the second communication apparatus can obtain a corresponding performance indicator.

A third aspect of this application provides a communication method, including:

A first communication apparatus receives a first signal from a second communication apparatus. The first communication apparatus performs nonlinear compensation on the first signal based on first coefficient information, to obtain a second signal. The first communication apparatus sends first performance indicator information to the second communication apparatus, where the first performance indicator information is determined based on a performance indicator of the second signal.

In the foregoing technical solution, the first communication apparatus performs nonlinear compensation on the first signal based on the first coefficient information, to obtain the second signal. Then, the first communication apparatus sends the first performance indicator information to the second communication apparatus, where the first performance indicator information is determined based on the performance indicator of the second signal. Therefore, the second communication apparatus may determine a nonlinear compensation status of the first coefficient information for the first signal and a benefit brought by the first coefficient information to performance of the second communication apparatus. In this way, the second communication apparatus can accurately determine transmit power or a backoff value of the PA, to implement higher transmit power or better signal sending quality, improve linearity of a signal output by the second communication apparatus, and finally improve a coverage area, a capacity, and the like of the second communication apparatus. This helps avoid problems such as performance deterioration of the second communication apparatus caused by improper coefficient information used by a network device.

A fourth aspect of this application provides a communication method, including:

A second communication apparatus generates a first signal. The second communication apparatus sends the first signal to a first communication apparatus. The second communication apparatus receives first performance indicator information from the first communication apparatus, where the first performance indicator information is determined based on a performance indicator of a second signal, and the second signal is obtained by the first communication apparatus by performing nonlinear compensation on the first signal based on first coefficient information.

In the foregoing technical solution, the second communication apparatus sends the first signal to the first communication apparatus. Then, the second communication apparatus receives the first performance indicator information from the first communication apparatus, where the first performance indicator information is determined based on the performance indicator of the second signal. The second signal is obtained by the first communication apparatus by performing nonlinear compensation on the first signal based on the first coefficient information. Therefore, the second communication apparatus may determine a nonlinear compensation status of the first coefficient information for the first signal and a benefit brought by the first coefficient information to performance of the second communication apparatus. In this way, the second communication apparatus can accurately determine transmit power or a backoff value of the PA, to implement higher transmit power or better signal sending quality, improve linearity of a signal output by the second communication apparatus, and finally improve a coverage area, a capacity, and the like of the second communication apparatus. This helps avoid problems such as performance deterioration of the second communication apparatus caused by improper coefficient information used by a network device.

Based on the third aspect, in a possible implementation, the method further includes: The first communication apparatus determines the performance indicator of the second signal. In this way, the first performance indicator information is sent to the second communication apparatus.

Based on the third aspect or the fourth aspect, in a possible implementation, the performance indicator of the second signal includes at least one of the following: an error vector magnitude, a signal to interference plus noise ratio, a signal-to-noise ratio, a supportable modulation and coding scheme, a channel quality indicator, a supportable highest modulation order, a mean squared error, a normalized mean squared error, or an adjacent channel leakage ratio of the second signal.

In this implementation, some possible forms of the performance indicator of the second signal are shown, so that the first communication apparatus determines the performance indicator of the second signal.

Based on the third aspect or the fourth aspect, in a possible implementation, the first performance indicator information includes the performance indicator of the second signal.

In this implementation, the first communication apparatus may report the performance indicator of the second signal to the second communication apparatus, so that the second communication apparatus determines a nonlinear compensation status for a PA and a benefit brought by the first coefficient information to performance of a network device. In this way, the second communication apparatus can accurately determine transmit power or a backoff value of the PA, to implement higher transmit power or better signal sending quality, improve linearity of a signal output by the second communication apparatus, and finally improve a coverage area, a capacity, and the like of the second communication apparatus.

Based on the third aspect or the fourth aspect, in a possible implementation, the first performance indicator information is determined based on the performance indicator of the first signal and the performance indicator of the second signal.

In this implementation, the first performance indicator may be determined together with reference to the performance indicator of the first signal before the nonlinear compensation and the performance indicator of the second signal after the nonlinear compensation, so that the first performance indicator information can be used to represent a value of a benefit brought by performing nonlinear compensation on the first signal by using the first coefficient information. In this way, the second communication apparatus can set appropriate transmit power for the PA, to implement higher transmit power or better signal sending quality, improve linearity of a signal output by the second communication apparatus, and finally improve a coverage area, a capacity, and the like of the second communication apparatus.

Based on the third aspect or the fourth aspect, in a possible implementation, the first performance indicator information includes: the performance indicator of the first signal and the performance indicator of the second signal; or the first performance indicator information includes: the performance indicator of the first signal and a variation between the performance indicator of the first signal and the performance indicator of the second signal; or the first performance indicator information includes: the performance indicator of the second signal and a variation between the performance indicator of the first signal and the performance indicator of the second signal.

In this implementation, some possible content included in the first performance indicator information is shown, so that the second communication apparatus determines the performance indicator of the first signal before the nonlinear compensation and the performance indicator of the second signal after the nonlinear compensation. In this way, the second communication apparatus can determine a value of a benefit brought by performing nonlinear compensation on the first signal by using the first coefficient information. In this way, the second communication apparatus can set appropriate transmit power for the PA,

Based on the third aspect or the fourth aspect, in a possible implementation, the variation between the performance indicator of the first signal and the performance indicator of the second signal includes at least one of the following: a variation between an error vector magnitude of the first signal and the error vector magnitude of the second signal; a variation between a signal-to-noise ratio of the first signal and the signal-to-noise ratio of the second signal; a variation between a channel quality indicator of the first signal and the channel quality indicator of the second signal; a variation between a mean squared error of the first signal and the mean squared error of the second signal; or a variation between a normalized mean squared error of the first signal and the normalized mean squared error of the second signal.

In this implementation, some possible forms of the variation between the performance indicator of the first signal and the performance indicator of the second signal are shown. Therefore, the second communication apparatus may determine a variation of each performance indicator of the second signal. In this way, the second communication apparatus can determine a value of a benefit brought by performing nonlinear compensation on the PA by using the first coefficient information.

Based on the third aspect, in a possible implementation, before the first communication apparatus receives the first signal from the second communication apparatus, the method further includes: The first communication apparatus receives indication information from the second communication apparatus, where the first indication information indicates location information of a time-frequency resource used by the second communication apparatus to send the first signal. In this implementation, the first communication apparatus determines the time-frequency resource of the first signal, so that the first communication apparatus receives the first signal.

Based on the fourth aspect, in a possible implementation, before the second communication apparatus sends the first signal to the first communication apparatus, the method further includes: The second communication apparatus sends indication information to the first communication apparatus, where the first indication information indicates location information of a time-frequency resource used by the second communication apparatus to send the first signal. In this way, the first communication apparatus can receive the first signal.

Based on the third aspect, in a possible implementation, the method further includes: The first communication apparatus sends the first coefficient information to the second communication apparatus, where the first coefficient information is determined based on the first signal. In this implementation, the first communication apparatus may determine the first coefficient information with reference to the first signal, and send the first coefficient information to the second communication apparatus, so that the second communication apparatus determines the first coefficient information corresponding to the first performance indicator information. In this way, the second communication apparatus can determine a value of a benefit brought by performing nonlinear compensation on the first signal by using the first coefficient information.

Based on the fourth aspect, in a possible implementation, the method further includes: The second communication apparatus receives the first coefficient information from the first communication apparatus. Therefore, the second communication apparatus may determine the first coefficient information corresponding to the first performance indicator information. In this way, the second communication apparatus can determine a value of a benefit brought by performing nonlinear compensation on the first signal by using the first coefficient information.

Based on the third aspect, in a possible implementation, the first coefficient information includes information about a predistortion parameter or information about an equivalent PA coefficient. That the first communication apparatus sends the first coefficient information to the second communication apparatus includes:

When the performance indicator of the second signal is abnormal, the first communication apparatus sends the first coefficient information to the second communication apparatus based on a first coefficient information reporting format, where the first coefficient information reporting format includes a reporting requirement for a nonlinear order and a memory depth in the predistortion parameter or the equivalent PA coefficient, and the first coefficient information reporting format indicates that the performance indicator of the second signal is abnormal.

In this implementation, when the performance indicator of the second signal is abnormal, the first communication apparatus sends the first coefficient information to the second communication apparatus based on the first coefficient information reporting format. Therefore, the second communication apparatus may indicate the performance indicator information of the second signal. In this way, the second communication apparatus can select another communication apparatus to re-obtain the coefficient information, to eliminate impact of factors such as poor channel quality of the first communication apparatus or burst interference. This helps the second communication apparatus obtain accurate coefficient information, and performs nonlinear compensation by using the coefficient information, to improve linearity of a signal output by the second communication apparatus, and finally improve a coverage area, a capacity, and the like of the second communication apparatus.

Based on the third aspect, in a possible implementation, the method further includes: The first communication apparatus sends, to the second communication apparatus, first time-frequency resource information associated with the first performance indicator information, where the first time-frequency resource information includes location information of a first time-frequency resource used by the first communication apparatus to receive the first signal, and the first performance indicator information is determined by the first communication apparatus based on the first signal received by the first communication apparatus on the first time-frequency resource. In this implementation, the first communication apparatus may send the first time-frequency resource information to the second communication apparatus, so that the second communication apparatus determines a performance indicator of a signal based on which the first performance indicator information is determined.

Based on the fourth aspect, in a possible implementation, the method further includes: The second communication apparatus sends, to the first communication apparatus, first time-frequency resource information associated with the first performance indicator information, where the first time-frequency resource information includes location information of a first time-frequency resource used by the first communication apparatus to receive the first signal, and the first performance indicator information is determined by the first communication apparatus based on the first signal received by the first communication apparatus on the first time-frequency resource. In this implementation, the second communication apparatus receives, from the first communication apparatus, the first time-frequency resource information associated with the first performance indicator information, so that the second communication apparatus determines a performance indicator of a signal based on which the first performance indicator information is determined.

Based on the third aspect, in a possible implementation, before the first communication apparatus sends the first performance indicator information to the second communication apparatus, the method further includes: The first communication apparatus receives first configuration information sent by the second communication apparatus, where the first configuration information indicates the first communication apparatus to report a reporting configuration of the first performance indicator information. That the first communication apparatus sends first performance indicator information to the second communication apparatus includes: The first communication apparatus sends the first performance indicator information to the second communication apparatus based on the reporting configuration. In this implementation, the first communication apparatus may send the first performance indicator information to the second communication apparatus based on the reporting configuration configured by the second communication apparatus. In this way, the second communication apparatus can obtain a corresponding performance indicator.

Based on the fourth aspect, in a possible implementation, before the second communication apparatus receives the first performance indicator information from the first communication apparatus, the method further includes: The second communication apparatus sends first configuration information to the first communication apparatus, where the first configuration information indicates the first communication apparatus to report a reporting configuration of the first performance indicator information. In this way, the second communication apparatus can obtain a corresponding performance indicator.

Based on the fourth aspect, in a possible implementation, that a second communication apparatus generates a first signal includes: The second communication apparatus performs precoding processing on a third signal based on a diagonal matrix, to obtain a fourth signal, where the third signal carries multi-stream data. The second communication apparatus processes the fourth signal through a first digital channel, to obtain the first signal. In this implementation, for the fourth signal that carries the multi-stream data, to facilitate the first communication apparatus to perform stream-by-stream nonlinear model training after channel equalization, and prevent an increase in processing complexity caused by inter-stream cross interference, the second communication apparatus may perform precoding processing on the fourth signal by using a diagonal matrix, to avoid inter-stream cross interference.

A fifth aspect of this application provides a first communication apparatus, including:
a transceiver module, configured to: receive a first signal from a second communication apparatus, where the first signal is a signal obtained by performing nonlinear compensation based on first coefficient information; and send first performance indicator information to the second communication apparatus, where the first performance indicator information is determined based on a performance indicator of the first signal.

A sixth aspect of this application provides a second communication apparatus, including:
a transceiver module, configured to: send a first signal to a first communication apparatus, where the first signal is a signal obtained by performing nonlinear compensation based on first coefficient information; and receive first performance indicator information from the first communication apparatus, where the first performance indicator information is determined based on a performance indicator of the first signal.

Based on the fifth aspect, in a possible implementation, the first communication apparatus further includes a processing module. The processing module is configured to determine the performance indicator of the first signal.

Based on the fifth aspect or the sixth aspect, in a possible implementation, the performance indicator of the first signal includes at least one of the following: an error vector magnitude, a signal to interference plus noise ratio, a signal-to-noise ratio, a supportable modulation and coding scheme, a channel quality indicator, a supportable highest modulation order, a mean squared error, a normalized mean squared error, or an adjacent channel leakage ratio of the first signal.

Based on the fifth aspect or the sixth aspect, in a possible implementation, the first performance indicator information includes the performance indicator of the first signal.

Based on the fifth aspect or the sixth aspect, in a possible implementation, the first performance indicator information is determined based on the performance indicator of the first signal and a performance indicator of a second signal, and the second signal is a signal that is received by the first communication apparatus from the second communication apparatus and on which nonlinear compensation is not performed.

Based on the fifth aspect or the sixth aspect, in a possible implementation, the first performance indicator information includes: the performance indicator of the first signal and the performance indicator of the second signal; or the first performance indicator information includes: the performance indicator of the first signal and a variation between the performance indicator of the first signal and the performance indicator of the second signal; or the first performance indicator information includes: the performance indicator of the second signal and a variation between the performance indicator of the first signal and the performance indicator of the second signal.

Based on the fifth aspect or the sixth aspect, in a possible implementation, the variation between the performance indicator of the first signal and the performance indicator of the second signal includes at least one of the following: a variation between the error vector magnitude of the first signal and an error vector magnitude of the second signal; a variation between the signal-to-noise ratio of the first signal and a signal-to-noise ratio of the second signal; a variation between the channel quality indicator of the first signal and a channel quality indicator of the second signal; a variation between the mean squared error of the first signal and a mean squared error of the second signal; or a variation between the normalized mean squared error of the first signal and a normalized mean squared error of the second signal.

Based on the fifth aspect, in a possible implementation, the transceiver module is further configured to: receive indication information from the second communication apparatus, where the indication information indicates time-frequency resource information of the first signal and time-frequency resource information of the second signal, the time-frequency resource information of the first signal indicates location information of a time-frequency resource used by the second communication apparatus to send the first signal, and the time-frequency resource information of the second signal indicates location information of a time-frequency resource used by the second communication apparatus to send the second signal.

Based on the sixth aspect, in a possible implementation, the transceiver module is further configured to: send indication information to the first communication apparatus, where the indication information indicates time-frequency resource information of the first signal and time-frequency resource information of the second signal, the time-frequency resource information of the first signal indicates location information of a time-frequency resource used by the second communication apparatus to send the first signal, and the time-frequency resource information of the second signal indicates location information of a time-frequency resource used by the second communication apparatus to send the second signal.

Based on the fifth aspect, in a possible implementation, the transceiver module is further configured to: send, to the second communication apparatus, first time-frequency resource information associated with the first performance indicator information, where the first time-frequency resource information includes location information of a first time-frequency resource used by the first communication apparatus to receive the first signal, and the first performance indicator information is determined by the first communication apparatus based on the first signal received by the first communication apparatus on the first time-frequency resource.

Based on the sixth aspect, in a possible implementation, the transceiver module is further configured to: receive, from the first communication apparatus, first time-frequency resource information associated with the first performance indicator information, where the first time-frequency resource information includes location information of a first time-frequency resource used by the first communication apparatus to receive the first signal, and the first performance indicator information is determined by the first communication apparatus based on the first signal received by the first communication apparatus on the first time-frequency resource.

Based on the fifth aspect or the sixth aspect, in a possible implementation, the first time-frequency resource information further includes location information of a second time-frequency resource used by the first communication apparatus to receive the second signal, and the first performance indicator information is determined by the first communication apparatus based on the first signal received by the first communication apparatus on the first time-frequency resource and the second signal received by the first communication apparatus on the second time-frequency resource.

Based on the fifth aspect, in a possible implementation, the transceiver module is further configured to:

receive the second signal from the second communication apparatus, where the second signal is a signal on which nonlinear compensation is not performed; and
the transceiver module is further configured to send the first coefficient information to the second communication apparatus, where the first coefficient information is determined based on the second signal.

Based on the sixth aspect, in a possible implementation, the transceiver module is further configured to: send the second signal to the first communication apparatus, where the second signal is a signal on which nonlinear compensation is not performed; and receive the first coefficient information from the first communication apparatus, where the first coefficient information is determined by the first communication apparatus based on the second signal.

Based on the sixth aspect, in a possible implementation, the transceiver module is further configured to: send a third signal to a third communication apparatus, where the third signal is a signal on which nonlinear compensation is not performed; and receive the first coefficient information from the third communication apparatus, where the first coefficient information is determined by the third communication apparatus based on the third signal.

Based on the fifth aspect or the sixth aspect, in a possible implementation, the first coefficient information includes any one of the following: information about a predistortion coefficient or information about an equivalent PA coefficient.

Based on the fifth aspect, in a possible implementation, the transceiver module is further configured to:

receive first configuration information sent by the second communication apparatus, where the first configuration information indicates the first communication apparatus to report a reporting configuration of the first performance indicator information; and
the transceiver module is specifically configured to send the first performance indicator information to the second communication apparatus based on the reporting configuration.

Based on the sixth aspect, in a possible implementation, the transceiver module is further configured to: send first configuration information to the first communication apparatus, where the first configuration information indicates the first communication apparatus to report a reporting configuration of the first performance indicator information.

A seventh aspect of this application provides a first communication apparatus, including:

a transceiver module, configured to receive a first signal from a second communication apparatus; and
a processing module, configured to perform nonlinear compensation on the first signal based on first coefficient information, to obtain a second signal, where
the transceiver module is further configured to send first performance indicator information to the second communication apparatus, where the first performance indicator information is determined based on a performance indicator of the second signal.

An eighth aspect of this application provides a second communication apparatus, including:
a transceiver module, configured to: send a first signal to a first communication apparatus; and receive first performance indicator information from the first communication apparatus, where the first performance indicator information is determined based on a performance indicator of a second signal, and the second signal is obtained by the first communication apparatus by performing nonlinear compensation on the first signal based on first coefficient information.

Based on the seventh aspect, in a possible implementation, the processing module is further configured to determine the performance indicator of the second signal.

Based on the seventh aspect or the eighth aspect, in a possible implementation, the performance indicator of the second signal includes at least one of the following: an error vector magnitude, a signal to interference plus noise ratio, a signal-to-noise ratio, a supportable modulation and coding scheme, a channel quality indicator, a supportable highest modulation order, a mean squared error, a normalized mean squared error, or an adjacent channel leakage ratio of the second signal.

Based on the seventh aspect or the eighth aspect, in a possible implementation, the first performance indicator information includes the performance indicator of the second signal.

Based on the seventh aspect or the eighth aspect, in a possible implementation, the first performance indicator information is determined based on the performance indicator of the first signal and the performance indicator of the second signal.

Based on the seventh aspect or the eighth aspect, in a possible implementation, the first performance indicator information includes: the performance indicator of the first signal and the performance indicator of the second signal; or the first performance indicator information includes: the performance indicator of the first signal and a variation between the performance indicator of the first signal and the performance indicator of the second signal; or the first performance indicator information includes: the performance indicator of the second signal and a variation between the performance indicator of the first signal and the performance indicator of the second signal.

Based on the seventh aspect or the eighth aspect, in a possible implementation, the variation between the performance indicator of the first signal and the performance indicator of the second signal includes at least one of the following: a variation between an error vector magnitude of the first signal and the error vector magnitude of the second signal; a variation between a signal-to-noise ratio of the first signal and the signal-to-noise ratio of the second signal; a variation between a channel quality indicator of the first signal and the channel quality indicator of the second signal; a variation between a mean squared error of the first signal and the mean squared error of the second signal; or a variation between a normalized mean squared error of the first signal and the normalized mean squared error of the second signal.

Based on the seventh aspect, in a possible implementation, the transceiver module is further configured to: receive indication information from the second communication apparatus, where the indication information indicates location information of a time-frequency resource used by the second communication apparatus to send the first signal.

Based on the eighth aspect, in a possible implementation, the transceiver module is further configured to: send indication information to the first communication apparatus, where the indication information indicates location information of a time-frequency resource used by the second communication apparatus to send the first signal.

Based on the seventh aspect, in a possible implementation, the transceiver module is further configured to send the first coefficient information to the second communication apparatus, where the first coefficient information is determined based on the first signal.

Based on the eighth aspect, in a possible implementation, the transceiver module is further configured to receive the first coefficient information from the first communication apparatus.

Based on the seventh aspect, in a possible implementation, the first coefficient information includes information about a predistortion coefficient or information about an equivalent PA coefficient; and the transceiver module is specifically configured to: when the performance indicator of the second signal is abnormal, send the first coefficient information to the second communication apparatus based on a first coefficient information reporting format, where the first coefficient information reporting format includes a reporting requirement for a nonlinear order and a memory depth in the predistortion parameter or the equivalent PA coefficient, and the first coefficient information reporting format indicates that the performance indicator of the second signal is abnormal.

Based on the seventh aspect, in a possible implementation, the transceiver module is further configured to send, to the second communication apparatus, first time-frequency resource information associated with the first performance indicator information, where the first time-frequency resource information includes location information of a first time-frequency resource used by the first communication apparatus to receive the first signal, and the first performance indicator information is determined by the first communication apparatus based on the first signal received by the first communication apparatus on the first time-frequency resource.

Based on the eighth aspect, in a possible implementation, the transceiver module is further configured to send, to the first communication apparatus, first time-frequency resource information associated with the first performance indicator information, where the first time-frequency resource information includes location information of a first time-frequency resource used by the first communication apparatus to receive the first signal, and the first performance indicator information is determined by the first communication apparatus based on the first signal received by the first communication apparatus on the first time-frequency resource.

Based on the seventh aspect, in a possible implementation, the transceiver module is further configured to:

receive first configuration information sent by the second communication apparatus, where the first configuration information indicates the first communication apparatus to report a reporting configuration of the first performance indicator information; and
the transceiver module is specifically configured to:
send the first performance indicator information to the second communication apparatus based on the reporting configuration.

Based on the eighth aspect, in a possible implementation, the transceiver module is further configured to send first configuration information to the first communication apparatus, where the first configuration information indicates the first communication apparatus to report a reporting configuration of the first performance indicator information.

Based on the eighth aspect, in a possible implementation, the processing module is specifically configured to perform precoding processing on a third signal based on a diagonal matrix, to obtain a fourth signal, where the third signal carries multi-stream data; and process the fourth signal through a first digital channel, to obtain the first signal.

A ninth aspect of this application provides a communication apparatus. The communication apparatus includes a processor. The processor is configured to invoke and run a computer program stored in a memory, to enable the processor to implement any one of the implementations of the first aspect to the fourth aspect.

Optionally, the communication apparatus further includes a transceiver. The processor is further configured to control the transceiver to receive and send a signal.

Optionally, the communication apparatus includes the memory. The memory stores the computer program.

A tenth aspect of this application provides a computer program product including instructions. When the computer program product runs on a computer, the computer is enabled to perform any one of the implementations of the first aspect to the fourth aspect.

An eleventh aspect of this application provides a computer-readable storage medium, including computer instructions. When the computer instructions are run on a computer, the computer is enabled to perform any one of the implementations of the first aspect to the fourth aspect.

A twelfth aspect of this application provides a chip apparatus, including a processor, configured to connect a memory and invoke a program stored in the memory, to enable the processor to perform any one of the implementations of the first aspect to the fourth aspect.

A thirteenth aspect of this application provides a communication system. The communication system includes the first communication apparatus in the fifth aspect and the second communication apparatus in the sixth aspect; or the communication system includes the first communication apparatus in the seventh aspect and the second communication apparatus in the eighth aspect.

It can be learned from the foregoing technical solutions that embodiments of this application have the following advantages:

It can be learned from the foregoing technical solutions that the first communication apparatus receives the first signal from the second communication apparatus, where the first signal is a signal obtained by performing nonlinear compensation based on the first coefficient information. Then, the first communication apparatus sends the first performance indicator information to the second communication apparatus, where the first performance indicator information is determined based on the performance indicator of the first signal. It can be learned that the first communication apparatus may report the first performance indicator information to the second communication apparatus, so that the second communication apparatus determines the performance indicator of the first signal. In this way, the second communication apparatus can determine a nonlinear compensation status of the first coefficient information for the PA, so that the second communication apparatus better compensates for nonlinear distortion of the PA, thereby improving linearity of a signal output by the second communication apparatus, and improving performance of the network device.

## BRIEF DESCRIPTION OF DRAWINGS

FIG. 1 is a diagram of a communication system according to an embodiment of this application;

FIG. 2 is another diagram of a communication system according to an embodiment of this application;

FIG. 3 is a diagram of compensating for signal nonlinear distortion caused by a PA through DPD processing according to an embodiment of this application;

FIG. 4a is a diagram of a function of a signal obtained through DPD processing according to an embodiment of this application;

FIG. 4b is a diagram of a function of a signal obtained through PA processing according to an embodiment of this application;

FIG. 4c is a diagram of a function of a signal obtained through DPD processing and PA processing according to an embodiment of this application;

FIG. 5 is a diagram of a hybrid beamforming (hybrid beamforming, HBF) system architecture according to an embodiment of this application;

FIG. 6 is a diagram in which a first communication apparatus assists a second communication apparatus in obtaining information about a DPD parameter of a digital channel 1 according to an embodiment of this application;

FIG. 7 is a diagram of an equivalent architecture of a digital channel in over-the-air digital predistortion (over-the-air digital predistortion, OTADPD) according to an embodiment of this application;

FIG. 8 is a diagram of calculating an error vector magnitude according to an embodiment of this application;

FIG. 9 is a diagram of calculating an adjacent channel leakage ratio according to an embodiment of this application;

FIG. 10 is a diagram of an embodiment of a communication method according to embodiments of this application;

FIG. 11A is a diagram of generating a first signal according to an embodiment of this application;

FIG. 11B is a diagram of an equivalent PA coefficient according to an embodiment of this application;

FIG. 12a is a diagram of transmit power of an equivalent PA of a second communication apparatus and an error vector magnitude of a corresponding signal on which nonlinear compensation is not performed according to an embodiment of this application;

FIG. 12b is another diagram of transmit power of an equivalent PA of a second communication apparatus and an error vector magnitude of a corresponding signal on which nonlinear compensation is not performed according to an embodiment of this application;

FIG. 12c is a diagram of transmit power of an equivalent PA of a second communication apparatus and an error vector magnitude of a signal obtained by performing nonlinear compensation by using accurate coefficient information according to an embodiment of this application;

FIG. 12d is a diagram of transmit power of an equivalent PA of a second communication apparatus and an error vector magnitude of a signal obtained by performing nonlinear compensation by using incorrect coefficient information according to an embodiment of this application;

FIG. 13A is a diagram of estimating a DPD coefficient according to an embodiment of this application;

FIG. 13B is a diagram of a scenario of a communication method according to an embodiment of this application;

FIG. 13C is a diagram of another scenario of a communication method according to an embodiment of this application;

FIG. 14A is a diagram of a time domain resource and a frequency domain resource occupied by a measurement resource according to an embodiment of this application;

FIG. 14B is another diagram of a time domain resource and a frequency domain resource occupied by a measurement resource according to an embodiment of this application;

FIG. 14C is a diagram of a sending period of a first signal and a slot offset of a measurement resource occupied by the first signal according to an embodiment of this application;

FIG. 15A is a diagram of spectrum broadening of a DPD model bandwidth according to an embodiment of this application;

FIG. 15B is a diagram of measuring a first signal by a first communication apparatus according to an embodiment of this application;

FIG. 16a is a diagram of a DPD coefficient reporting format according to an embodiment of this application;

FIG. 16b is another diagram of a DPD coefficient reporting format according to an embodiment of this application;

FIG. 16c is another diagram of a DPD coefficient reporting format according to an embodiment of this application;

FIG. 16d is another diagram of a DPD coefficient reporting format according to an embodiment of this application;

FIG. 17 is a diagram of another embodiment of a communication method according to embodiments of this application;

FIG. 18 is a diagram of determining a second signal by a first communication apparatus according to an embodiment of this application;

FIG. 19 is a diagram of obtaining and reporting first coefficient information and first performance indicator information according to an embodiment of this application;

FIG. 20a is a diagram of a first coefficient information reporting format according to an embodiment of this application;

FIG. 20b is another diagram of a first coefficient information reporting format according to an embodiment of this application;

FIG. 20c is another diagram of a first coefficient information reporting format according to an embodiment of this application;

FIG. 21a is another diagram of a first coefficient information reporting format according to an embodiment of this application;

FIG. 21b is another diagram of a first coefficient information reporting format according to an embodiment of this application;

FIG. 21c is another diagram of a first coefficient information reporting format according to an embodiment of this application;

FIG. 22 is a diagram of a structure of a first communication apparatus according to an embodiment of this application;

FIG. 23 is a diagram of a structure of a second communication apparatus according to an embodiment of this application;

FIG. 24 is a diagram of a structure of a communication apparatus according to an embodiment of this application;

FIG. 25 is a diagram of a structure of a terminal device according to an embodiment of this application; and

FIG. 26 is a diagram of a structure of a network device according to an embodiment of this application.

## DESCRIPTION OF EMBODIMENTS

Embodiments of this application provide a communication method and a related apparatus, so that a first communication apparatus reports first performance indicator information to a second communication apparatus, thereby helping the second communication apparatus determine a performance indicator of a first signal. In this way, the second communication apparatus can determine a nonlinear compensation status of the first coefficient information for an equivalent PA, so that the second communication apparatus better compensates for nonlinear distortion of the equivalent PA, thereby improving linearity of a signal output by the second communication apparatus, and improving performance of a network device

The following clearly and completely describes the technical solutions in embodiments of this application with reference to the accompanying drawings in embodiments of this application. It is clear that the described embodiments are merely some but not all of embodiments of this application. All other embodiments obtained by a person skilled in the art based on embodiments of this application without creative efforts shall fall within the protection scope of this application.

Reference to "an embodiment", "some embodiments", or the like described in this application means that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

In descriptions of this application, unless otherwise specified, "/" means "or". For example, A/B may indicate A or B. A term "and/or" in this specification describes only an association relationship between associated objects and indicates that there may be three relationships. For example, A and/or B may represent the following three cases: Only A exists, both A and B exist, and only B exists. In addition, "at least one" means one or more, and "a plurality of" means two or more. At least one of the following items (pieces) or a similar expression thereof indicates any combination of these items, including a single item (piece) or any combination of a plurality of items (pieces). For example, at least one of a, b, or c may represent a, b, c, a and b, a and c, b and c, or a, b, and c. a, b, and c each may be singular or plural.

The technical solutions in embodiments of this application may be applied to various communication systems, for example, a 5th generation (5th generation, 5G) system or a new radio (new radio, NR) system, a long term evolution (long term evolution, LTE) system, an LTE frequency division duplex (frequency division duplex, FDD) system, an LTE time division duplex (time division duplex, TDD) system, a universal mobile telecommunications system (universal mobile telecommunications system, UMTS), a mobile communication system after a 5G network (for example, a 6G mobile communication system), and a vehicle to everything (vehicle to everything, V2X) communication system.

The communication system to which this application is applicable includes a first communication apparatus and a second communication apparatus. The first communication apparatus is a terminal device, and the second communication apparatus is a network device. Alternatively, the first communication apparatus is a network device, and the second communication apparatus is a terminal device. Alternatively, both the first communication apparatus and the second communication apparatus are network devices. Alternatively, both the first communication apparatus and the second communication apparatus are terminal devices. This is not specifically limited in this application. The following mainly describes the technical solutions of this application by using an example in which the first communication apparatus is a terminal device and the second communication apparatus is a network device.

The following describes the terminal device and the network device in this application.

The terminal device may be a wireless terminal device that can receive scheduling and indication information of a network device. The wireless terminal device may be a device that provides a user with voice and/or data connectivity, or a handheld device with a wireless connection function, or another processing device connected to a wireless modem.

The terminal device is also referred to as user equipment (user equipment, UE), a mobile station (mobile station, MS), a mobile terminal (mobile terminal, MT), or a customer premises equipment (customer premises equipment, CPE), and is a device that includes a wireless communication function (providing a user with voice/data connectivity), for example, a handheld device or a vehicle-mounted device with a wireless connection function. Currently, some examples of the terminal devices are: a mobile phone (mobile phone), a tablet computer, a notebook computer, a palmtop computer, a mobile internet device (mobile internet device, MID), a wearable device, a medical device, an industrial device, a virtual reality (virtual reality, VR) device, an augmented reality (augmented reality, AR) device, a wireless terminal in industrial control (industrial control), a wireless terminal in the internet of vehicles, a wireless terminal in self-driving (self-driving), a wireless terminal in remote medical surgery (remote medical surgery), a wireless terminal in smart grid (smart grid), a wireless terminal in transportation safety (transportation safety), a wireless terminal in smart city (smart city), a wireless terminal in smart home (smart home), or the like. For example, the wireless terminal in the Internet of Vehicles may be an in-vehicle device, an entire vehicle device, an in-vehicle module, a vehicle, or the like. The wireless terminal in industrial control may be a camera, a robot, or the like. The wireless terminal in the smart home may be a television, an air conditioner, a sweeper, a speaker, a set-top box, or the like.

The network device may be a device in a wireless network. For example, the network device is a device that is deployed in a radio access network and that provides a wireless communication function for the terminal device. For example, the network device may be a radio access network (radio access network, RAN) node that connects the terminal device to the wireless network, and may also be referred to as an access network device.

The network device includes but is not limited to: an evolved NodeB (evolved NodeB, eNB), a radio network controller (radio network controller, RNC), an NB, a base station controller (base station controller, BSC), a base transceiver station (base transceiver station, BTS), a home base station (for example, a home evolved NodeB or a home NodeB, HNB), a baseband unit (baseband unit, BBU), an access point (access point, AP) in a wireless fidelity (wireless fidelity, Wi-Fi) system, a radio relay node, a wireless backhaul node, a transmission point (transmission point, TP), a transmission reception point (transmission reception point, TRP), or the like; or may be a network device in a 5G mobile communication system, for example, a next generation NodeB (next generation NodeB, gNB), a transmission reception point (transmission reception point, TRP), or a transmission point (transmission point, TP) in a new radio (new radio, NR) system; or one antenna panel or a group of antenna panels (including a plurality of antenna panels) of a base station in a 5G mobile communication system. Alternatively, the network device may be a network node that forms a gNB or a transmission point, for example, a baseband unit (baseband unit, BBU) or a distributed unit (distributed unit, DU).

In some deployments, a gNB may include a central unit (central unit, CU) and a DU. The gNB may further include an active antenna unit (active antenna unit, AAU). The CU implements some functions of the gNB, and the DU implements some functions of the gNB.

For example, the CU is responsible for processing a non-real-time protocol and service, and implements functions of a radio resource control (radio resource control, RRC) layer and a packet data convergence protocol (packet data convergence protocol, PDCP) layer. The DU is responsible for processing a physical layer protocol and a real-time service, and implementing functions of a radio link control (radio link control, RLC) layer, a medium access control (medium access control, MAC) layer, and a physical (physical, PHY) layer. The AAU implements some physical layer processing functions, radio frequency processing, and a function related to an active antenna. The information at the RRC layer is finally changed to the information at the PHY layer, or is changed from the information at the PHY layer. Therefore, in this architecture, the higher layer signaling (for example, the RRC layer signaling) may also be considered to be sent by the DU, or sent by the DU and the AAU. It may be understood that the network device may be a device including one or more of a CU node, a DU node, and an AAU node. In addition, the CU may be classified into a network device in an access network (radio access network, RAN), or the CU may be classified into a network device in a core network (core network, CN). This is not limited in this application.

The following describes two possible communication systems to which this application is applicable. This application is also applicable to another communication system. This is not specifically limited in this application.

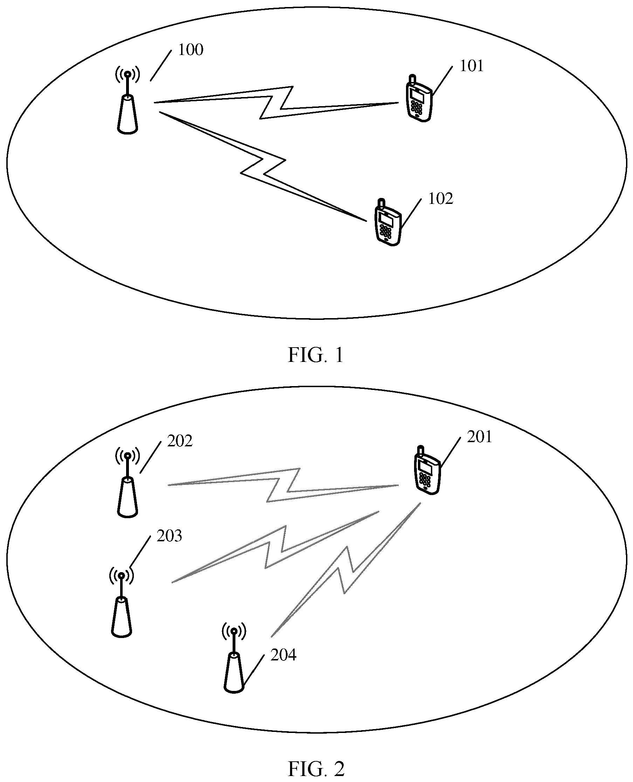

FIG. 1 is a diagram of a communication system according to an embodiment of this application. Refer to FIG. 1. The communication system includes at least one network device and at least one terminal device. As shown in FIG. 1, there are a network device 100, a terminal device 101, and a terminal device 102. The network device 100 may separately perform communication transmission with the terminal device 101 and the terminal device 102.

FIG. 2 is another diagram of a communication system according to an embodiment of this application. Refer to FIG. 2. The communication system includes at least one network device and at least one terminal device. As shown in FIG. 2, there are a terminal device 201, a network device 202, a network device 203, and a network device 204. The terminal device 201 may perform communication transmission with a plurality of network devices, so that the plurality of network devices provide a communication service for one terminal device.

A PA can amplify a low power signal generated by a network device or a terminal device to a power level that can be used for long-distance transmission, to implement long-distance communication. Therefore, the PA is a core component of a wireless communication device. When the PA amplifies power of a signal, the PA causes nonlinear distortion, deteriorating a performance indicator of a transmitted signal. For example, the nonlinear distortion caused by the PA may result in performance degradation of an error vector magnitude and an adjacent channel leakage ratio of the transmitted signal.

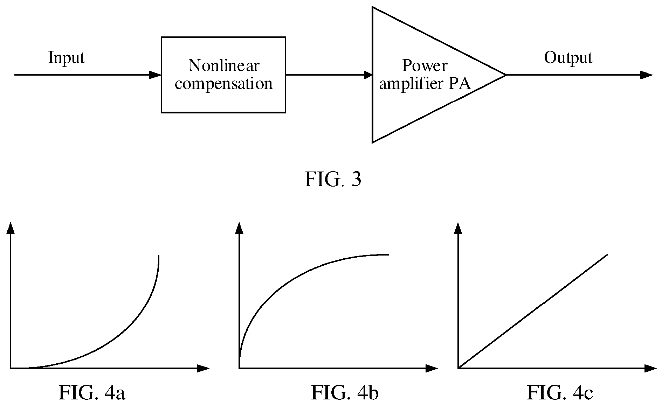

A digital predistortion (digital predistortion, DPD) technology is an effective means to improve linearity of a signal output by the PA. A specific principle includes: As shown in FIG. 3, before a signal passes through the PA, nonlinear compensation (which may also be referred to as DPD processing) is first performed on the signal, and then the signal passes through the PA, so that linearity of an output signal is improved. A signal obtained by performing nonlinear compensation on an input signal may be represented by using a function shown in FIG. 4a, and a signal obtained by performing PA processing on an input signal may be represented by using a function shown in FIG. 4b. Therefore, a signal obtained by performing nonlinear compensation and PA processing on an input signal shown in FIG. 3 may be represented by using a function shown in FIG. 4c.

In a frequency band such as a high frequency band or a millimeter wave, a second communication apparatus uses more antennas to obtain an array gain, to resist a larger propagation loss of a high-frequency signal. For example, in a frequency band from 26 GHz (gigahertz) to 28 GHz, a quantity of arrays included in the second communication apparatus may reach hundreds or thousands. To avoid excessively high costs and power consumption caused by a large-scale array, the second communication apparatus may use an analog beamforming (analog beamforming, ABF) system architecture or an HBF system architecture. Certainly, the second communication apparatus may alternatively use another system architecture. This is not specifically limited in this application. The following describes the HBF system architecture.

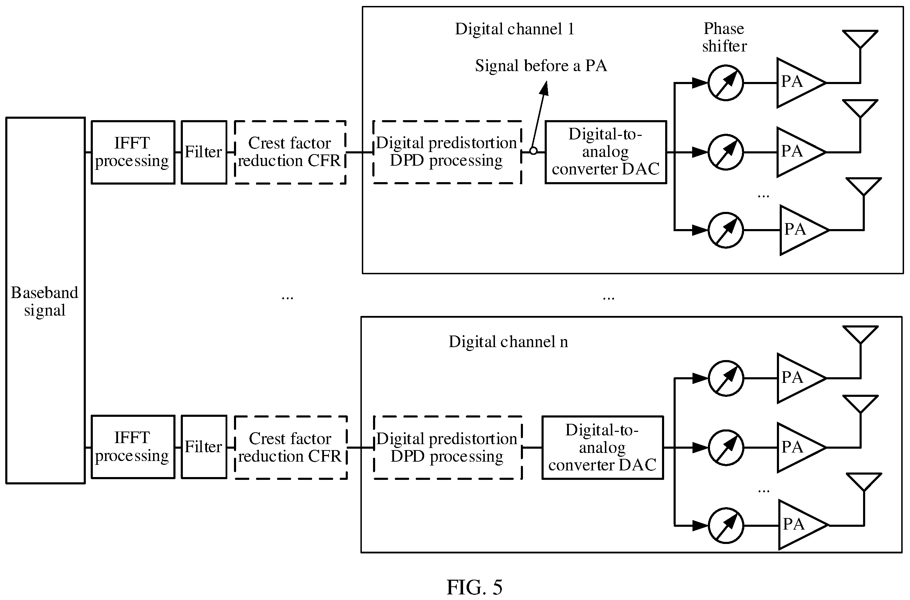

FIG. 5 is a diagram of an HBF system architecture according to an embodiment of this application. As shown in FIG. 5, one or more digital channels exist in a second communication apparatus, each digital channel corresponds to one or more PAs, and each PA is connected to one antenna array. A first communication apparatus may assist the second communication apparatus in obtaining DPD coefficient information corresponding to each digital channel. In other words, the technical solutions of this application are mainly for an OTA DPD scenario, so that a signal is transmitted between the first communication apparatus and the second communication apparatus through an air interface, to obtain the DPD coefficient information corresponding to the digital channel.

This application is applicable to a scenario in which a coverage capability is strong and energy consumption of a transmitting end is low, such as enhanced mobile broadband (enhanced mobile broadband, eMBB) and massive machine-type communication (massive machine-type communication, mMTC). It should be noted that a communication system to which this application is applicable is not limited to a cyclic prefix-orthogonal frequency division multiplexing (cyclic prefix-orthogonal frequency division multiplexing, CP-OFDM) system or a discrete Fourier transform spread orthogonal frequency division multiplexing (discrete Fourier transform-spread-OFDM, DFT-s-OFDM) system. In this application, a time domain symbol may be an OFDM symbol or a DFT-s-OFDM symbol.

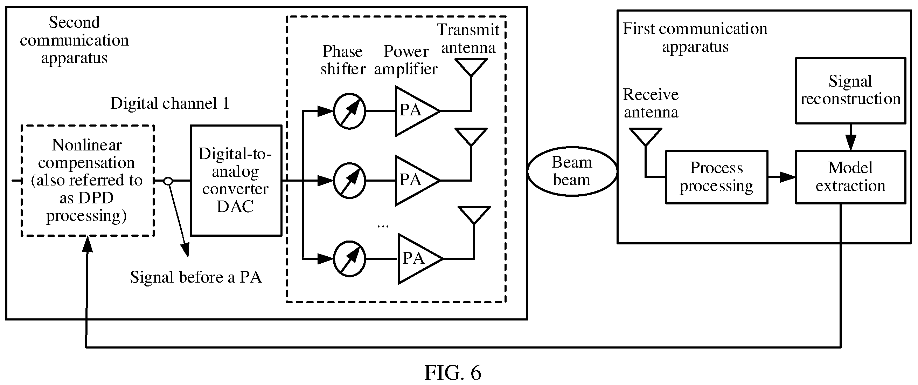

FIG. 6 is a diagram in which a first communication apparatus assists a second communication apparatus in obtaining information about a DPD parameter of a digital channel 1. Refer to FIG. 6. The digital channel 1 of the second communication apparatus corresponds to a DPD module, a digital-to-analog converter (digital-to-analog converter, DAC), a phase shifter, a plurality of PAs, and a plurality of transmit antenna arrays (which may also be referred to as transmit antennas). The DPD module is configured to perform nonlinear compensation on a signal. The DAC is configured to convert a digital signal into an analog signal.

The first communication apparatus includes a receive antenna, a process module, a signal reconstruction module, and a model extraction module. The process module is configured to perform channel estimation, equalization, measurement signal combination, and the like. The signal reconstruction module is configured to reconstruct a signal before a PA. The model extraction module is configured to determine DPD coefficient information corresponding to the digital channel 1. The DPD coefficient information may be used to compensate for signal nonlinear distortion caused by one or more PAs corresponding to the digital channel 1.

It should be noted that, in a process of transmitting a measurement signal between the first communication apparatus and the second communication apparatus, nonlinear compensation is not performed on the measurement signal. After the first communication apparatus obtains the DPD coefficient information, the first communication apparatus feeds back the DPD coefficient information to the second communication apparatus. When the second communication apparatus sends a data signal, the second communication apparatus may perform nonlinear compensation on the data signal based on the DPD coefficient information, to implement compensation for the data signal in advance. Then, a data signal obtained through compensation is processed by the phase shifter and the PA, and is sent to the first communication apparatus via the transmit antenna.

As described above, in the HBF system architecture, one digital channel of a transmitter corresponds to one or more PAs, and usually corresponds to hundreds to thousands of PAs. In addition, each PA may have a different nonlinear characteristic. Because there are excessive PAs, the transmitter in the HBF system architecture usually cannot implement nonlinear correction of PAs one by one. An OTA-DPD technology can resolve the foregoing problem. Researches show that a nonlinear effect of a plurality of PA combined signals may be equivalent to a nonlinear effect of a single PA.

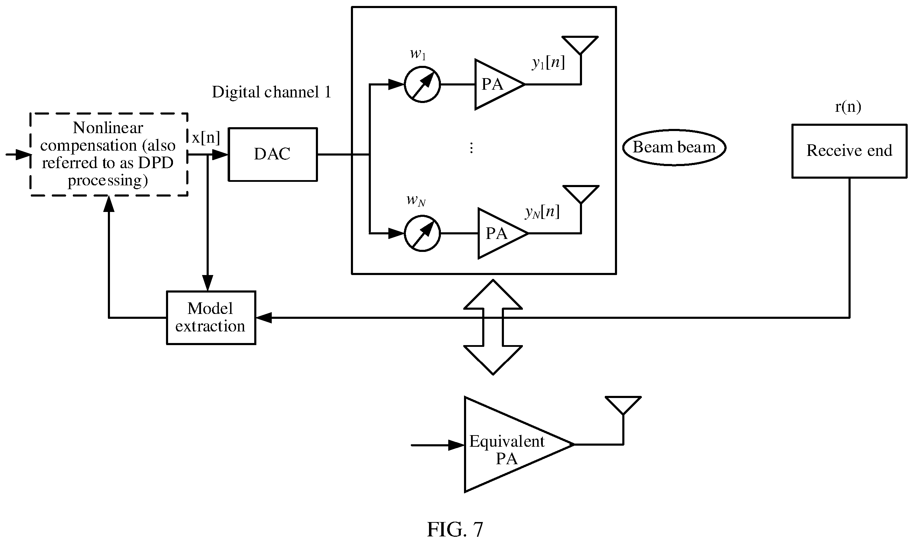

For example, FIG. 7 is a diagram of an equivalent architecture of a digital channel in OTA-DPD. If a signal before entering the DAC is represented as x[n], the signal before entering the DAC may be referred to as a signal before the PA. An analog beamforming weight vector $w = [w_1, w_2, .......]^T$, where the analog beamforming weight vector includes a weight used by the phase shifter corresponding to the digital channel 1. For example, a receiving end device may model the PA by using a memory polynomial (memory polynomial, MP). If a coefficient of an $i^{th}$ PA is represented as $a_{k,m}^{(i)}$, a signal output by the $i^{th}$ PA $y_i[n]$ may be represented as Formula 1:

$$y_i[n] = \sum_k \sum_m a_{k,m}^{(i)} \left| w_i \right|^{2k} w_i \left| x[n-m] \right|^{2k} x[n-m] \quad \text{Formula 1}$$

k is a nonlinear order used for the PA modeling, m is a memory depth used for the PA modeling, and n is a time domain position of a sampling point for performing sampling on the signal before the PA.

A receive antenna of the receiving end device is considered, and r[n] received by the receiving end device may be written as Formula 2:

$$r[n] = \sum_i h_i y_i[n] = \sum_i h_i \sum_k \sum_m a_{k,m}^{(i)} \left|w_i\right|^{2k} w_i \left|x[n-m]\right|^{2k} x[n-m]$$

$$= \sum_k \sum_m \gamma_{k,m} \left|x[n-m]\right|^{2k} x[n-m] \qquad \text{Formula 2}$$

$h_i$ is a channel between an $i^{th}$ antenna of a transmitting end device and a receive antenna of the receiving end device, $\gamma_{k,m} = \sum_i h_i \beta_{k,m}^{(i)} = \sum_i h_i a_{k,m}^{(i)} \left|w_i\right|^{2k} w_i$, and it is assumed that an amplitude of the foregoing weight $w_i$ is 1.

It can be learned from Formula 1 and Formula 2 that, at the receiving end device, a plurality of PAs corresponding to one digital channel of the transmitting end device may be equivalent to one PA, and a model coefficient of the equivalent PA is $\gamma_{k,m}$.

It can be learned from the foregoing descriptions that the transmitting end device may compensate for nonlinear effects of all PAs on a single digital channel. Specifically, the receiving end device may feed back, to the transmitting end device, DPD coefficient information corresponding to the digital channel. Specifically, the receiving end device receives a signal over an air interface, and determines, based on the received signal, the DPD coefficient information corresponding to the digital channel. It should be noted that the signal received by the receiving end device is a combination of a plurality of PA amplified signals corresponding to the digital channel, specifically as shown in Formula 2. Therefore, the signal received by the receiving end device includes superposition of the nonlinear effects of the plurality of PAs corresponding to the digital channel. Therefore, the receiving end device obtains, based on the received signal, the DPD coefficient information corresponding to the digital channel, and feeds back the information to the transmitting end device. In this way, the transmitting end device may compensate for signal nonlinear distortion caused by the plurality of PAs corresponding to the digital channel based on the DPD coefficient information corresponding to the digital channel.

For ease of understanding embodiments of this application, the following first briefly describes several terms used in this application.

1. A beam may be represented in an NR protocol as a spatial domain filter (spatial domain filter), which is also referred to as a spatial filter (spatial filter), a spatial domain parameter (spatial domain parameter), a spatial parameter (spatial parameter), a spatial domain setting (spatial domain setting), a spatial setting (spatial setting), quasi-colocation (quasi-colocation, QCL) information, a QCL assumption, a QCL indication, or the like. The beam may be indicated via a transmission configuration indicator state (transmission configuration indicator state, TCI-state) parameter or indicated via a spatial relation (spatial relation) parameter. Therefore, in this application, the beam may be replaced with a spatial domain filter, a spatial filter, a spatial domain parameter, a spatial parameter, a spatial domain setting, a spatial setting, QCL information, QCL assumption, QCL indication, a TCI-state (including an uplink TCI-state or a downlink TCI-state), a spatial relation, or the like. The foregoing terms are also equivalent to each other. The beam may alternatively be replaced with another term for representing the beam. This is not limited in this application.

A beam used to transmit a signal may be referred to as a transmit beam (transmit beam, Tx beam), or may be referred to as a spatial domain transmission filter (spatial domain transmission filter), a spatial transmission filter (spatial transmission filter), a spatial domain transmission parameter (spatial domain transmission parameter), a spatial transmission parameter (spatial transmission parameter), a spatial domain transmission setting (spatial domain transmission setting), or a spatial transmission setting (spatial transmission setting). A downlink transmit beam may be indicated via a TCI-state.

A beam used to receive a signal may be referred to as a receive beam (receive beam, Rx beam), or may be referred to as a spatial domain reception filter (spatial domain reception filter), a spatial reception filter (spatial reception filter), a spatial domain reception parameter (spatial domain reception parameter), a spatial reception parameter (spatial reception parameter), a spatial domain reception setting (spatial domain reception setting), or a spatial reception setting (spatial reception setting). An uplink transmit beam may be indicated via a spatial relation, an uplink TCI-state, or a channel sounding reference signal (sounding reference signal, SRS) resource (indicating a transmit beam that uses an SRS). Therefore, the uplink beam may alternatively be replaced with an SRS resource.

The transmit beam may be signal strength distribution formed in different directions in space after a signal is transmitted through an antenna, and the receive beam may be signal strength distribution, in different directions in space, of a radio signal received from an antenna.

In addition, the beam may be a wide beam, a narrow beam, or a beam of another type. A technology for forming the beam may be a beamforming technology or another technology. The beamforming technology may be specifically a digital beamforming technology, an analog beamforming technology, a hybrid digital beamforming technology, a hybrid analog beamforming technology, or the like.

The beam corresponds to configuration information of the reference signal. For example, when performing beam measurement, a network device may determine quality of different beams based on quality of different reference signals. A terminal device measures the reference signal, and feeds back quality of the reference signal to the network device. The network device may determine quality of the beam based on the quality of the reference signal. For the configuration information of the reference signal, refer to the following related descriptions. During data transmission, beam information is also indicated via configuration information of a reference signal corresponding to the beam information. For example, the network device indicates information about a physical downlink shared channel (physical downlink shared channel, PDSCH) beam of the terminal device via a TCI field in downlink control information (downlink control information, DCI). In a possible implementation, a plurality of beams having the same or similar communication characteristics are considered as one beam.

2. Configuration information of a reference signal includes a related parameter of the reference signal, for example, a sending period and a used time-frequency resource of the reference signal. The reference signal may be an uplink reference signal or a downlink reference signal. The uplink reference signal includes but is not limited to a sounding reference signal (sounding reference signal, SRS) and a demodulation reference signal (demodulation reference signal, DMRS). The downlink reference signal includes but is not limited to a channel state information-reference signal (channel state information-reference signal, CSI-RS), a cell-specific reference signal (cell-specific reference signal, CS-RS), a UE-specific reference signal (user equipment-specific reference signal, US-RS), a demodulation reference signal (demodulation reference signal, DMRS), and a synchronization signal/physical broadcast channel block (synchronization system/physical broadcast channel block, SS/PBCH block). The SS/PBCH block may be referred to as a synchronization signal block (synchronization signal block, SSB) for short.

The configuration information of the reference signal may be configured via RRC signaling. In terms of a configuration structure, the configuration information of the reference signal corresponds to a data structure, and includes a related parameter of an uplink reference signal corresponding to the configuration information or a related parameter of a downlink reference signal corresponding to the configuration information. For example, for the uplink reference signal, the configuration information of the reference signal includes at least one of the following: a type of the uplink reference signal, a resource element (which may also be referred to as a time-frequency resource) for carrying the uplink reference signal, sending time and a sending period of an uplink channel, an antenna port configured to send the uplink reference signal, and the like. For the downlink reference signal, the configuration information of the reference signal includes at least one of the following: a type of the downlink reference signal, a resource element (which may also be referred to as a time-frequency resource) for carrying the downlink reference signal, sending time and a sending period of the downlink reference signal, an antenna port configured to send the downlink reference signal, and the like.

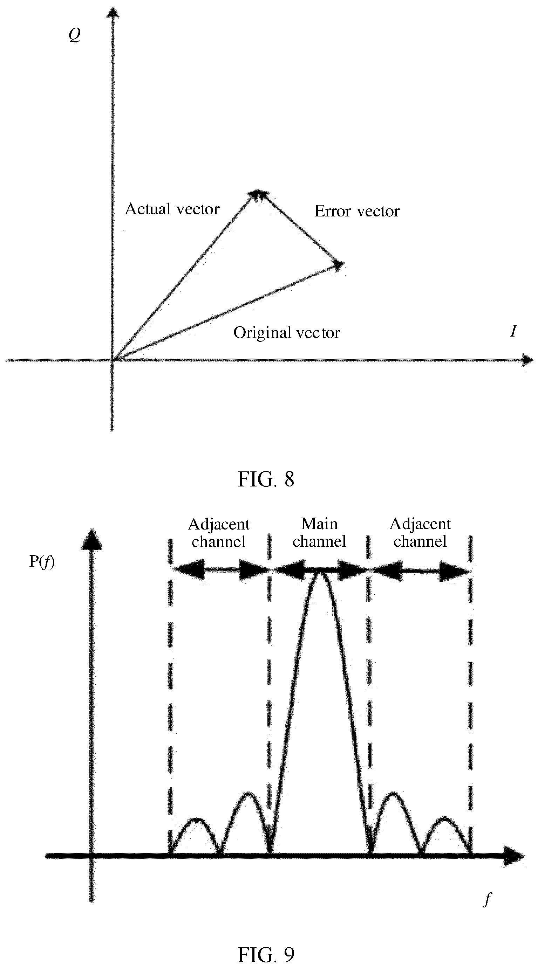

3. Error vector magnitude (error vector magnitude, EVM): In an actual communication system, a deviation occurs between a signal constellation diagram obtained after demodulation by a receiving end device and a signal constellation diagram of an ideal (original) signal due to factors such as a nonlinear characteristic of a PA or a channel estimation error, and more severe nonlinearity of the PA indicates a larger deviation. The EVM can well describe a signal in-band distortion status. As shown in FIG. 8, the EVM is determined by a deviation between an actual vector of each constellation point in a demodulated constellation diagram and an original vector of each constellation point in an original constellation diagram. A specific definition is as follows:

$$EVM = \sqrt{\frac{mean[(I_r - I_o)^2 + (Q_r - Q_o)^2]}{mean(I_o^2 + Q_o^2)}} \times 100\% \quad \text{Formula 3}$$

$(I_r, Q_r)$ is a constellation diagram obtained after the received signal is demodulated, and $(I_o, Q_o)$ is a constellation diagram of the original signal. $(I_r - I_o)^2$ represents a square of a difference between an I-channel modulation symbol of each constellation point in the constellation diagram obtained after the received signal is demodulated and an I-channel modulation symbol of a constellation point at a same location as the constellation point in the constellation diagram of the original signal. $(Q_r - Q_o)^2$ represents a square of a difference between an I-channel modulation symbol of each constellation point in the constellation diagram obtained after the received signal is demodulated and an I-channel modulation symbol of a constellation point at a same location as the constellation point in the constellation diagram of the original signal. $mean[(I_r - I_o)^2 + (Q_r - Q_o)^2]$ represents taking an average of a sum of $(I_r - I_o)^2$ and $(Q_r - Q_o)^2$. $I_o^2$ represents a square of an I-channel modulation symbol of each constellation point in the constellation diagram of the original signal. $Q_o^2$ represents a square of a Q-channel modulation symbol of each constellation point in the constellation diagram of the original signal. $mean(I_o^2 + Q_o^2)$ represents taking an average of a sum of $I_o^2$ and $Q_o^2$.

4. Adjacent channel leakage ratio: Nonlinear characteristic of a PA causes distortion of an intermodulation signal. As a result, a spectrum of an original signal is broadened to both sides. The adjacent channel leakage ratio is used to measure an out-of-band radiation characteristic of a transmitter, and is defined as a ratio of a signal power of a signal falling into an adjacent frequency band (that is, an adjacent channel) to a signal power of a main frequency band (that is, a main channel). As shown in FIG. 9, because signal spreading exists on both sides of the main channel, an average power of left and right adjacent bands (left and right channels) is generally used. A specific definition is as follows:

$$ACLR(dB) = 10lg\frac{P_{adj1}+P_{adj2}}{2P_{main}} \quad \text{Formula 4}$$

$P_{adj1}$ is power of the left channel, $P_{adj2}$ is power of the right channel, and $P_{main}$ is power of the main channel. A smaller ACLR value indicates less interference from the main channel to the adjacent channel and better communication performance.

In this application, a network device may configure a resource for a reference signal of a terminal device. The resource may be understood as a time-frequency resource that is configured in configuration information of the reference signal and that is used to carry the reference signal. Each resource corresponds to a corresponding antenna port, and the antenna port is specifically represented as configuration information of the reference signal.

In this application, in the following embodiments, a first signal may be referred to as a first measurement signal, a second signal may be referred to as a second measurement signal, and a third signal may be referred to as a third measurement signal. This is not specifically limited in this application.

The following describes the technical solutions of this application with reference to specific embodiments.

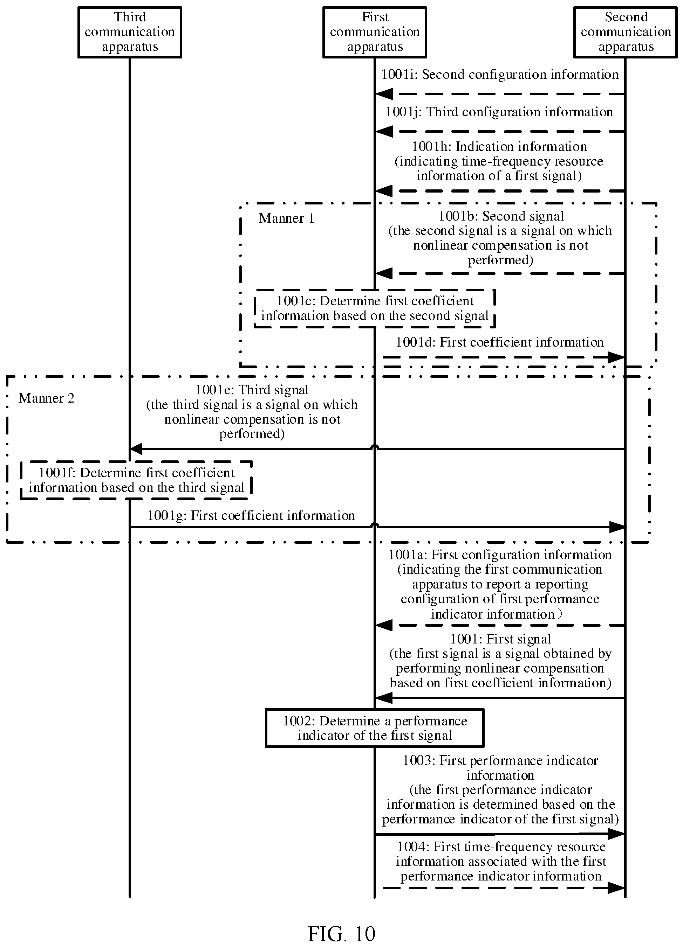

FIG. 10 is a diagram of an embodiment of a communication method according to embodiments of this application. Refer to FIG. 10. The method includes the following steps.

1001: A second communication apparatus sends a first signal to a first communication apparatus. Correspondingly, the first communication apparatus receives the first signal from the second communication apparatus.

The first signal is a signal obtained by performing nonlinear compensation based on first coefficient information.

Optionally, the first signal is a reference signal. For the reference signal, refer to the foregoing related descriptions in the configuration information of the reference signal.

Specifically, the second communication apparatus may send the first signal to the first communication apparatus by using a first resource. Correspondingly, the first communication apparatus receives the first signal from the second communication apparatus by using the first resource. As shown in FIG. 5, the first resource corresponds to a first antenna port, and the first antenna port corresponds to a digital channel 1. The digital channel 1 corresponds to a plurality of PAs. That is, the first signal is sent by using the first antenna port, or it may be understood that the second communication apparatus may process the first signal by using DPD corresponding to the digital channel 1, and a DAC, a plurality of phase shifters, and a plurality of PAs that correspond to the digital channel 1, and send a processed first signal by using a plurality of transmit antennas corresponding to the digital channel 1. It should be noted that the second communication apparatus performs nonlinear compensation on the first signal based on the first coefficient information. For the first resource, refer to the following related descriptions.

Optionally, the first coefficient information includes information about a DPD coefficient or information about an equivalent PA coefficient.

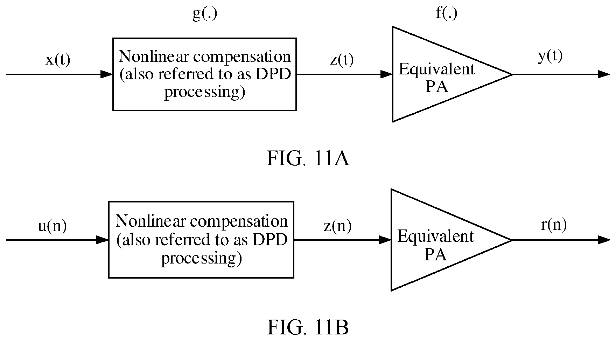

For example, as shown in FIG. 11A, the first coefficient information includes the information about the DPD coefficient, and a DPD equivalent function corresponding to the DPD coefficient is $g(\cdot)$. As shown in FIG. 5, an equivalent function that is of the second communication apparatus and that corresponds to the plurality of PAs corresponding to the digital channel 1 is represented as $f(\cdot)$, and a to-be-transmitted signal of the second communication apparatus is represented as $x(t)$, and a signal obtained through DPD is $z(t) = g(x(t))$. A signal that passes through the PA is the foregoing first information, and the first signal may be specifically represented as $y(t) = f(z(t)) = f(g(x(t)))$.

For example, the first coefficient information includes the information about the equivalent PA coefficient. The second communication apparatus may determine the information about the DPD coefficient based on a DPD coefficient training algorithm and the information about the equivalent PA coefficient. Optionally, the DPD coefficient training algorithm includes a direct learning algorithm or an indirect learning algorithm. For example, for the direct learning algorithm, a DPD module and a PA module on the second communication apparatus are considered as a whole, to perform iterative update on the DPD coefficient, thereby ensuring that an input signal input to the DPD module is equal to an output signal of the PA (an amplification gain part is not considered), that is, a signal u(n) shown in FIG. 11B is equal to a signal r(n). Then, the second communication apparatus calculates a signal x(n) output by the DPD module. It should be noted that, if a PA model in the PA module is known, the second communication apparatus determines the DPD coefficient based on a second-order Newton algorithm or a model splitting iterative algorithm.

A core idea of the direct learning algorithm is to minimize an error e(n) between the signal u(n) and the signal r(n). Specifically, e(n) may be represented as Formula 5.

$$e(n)=r(n)/G-u(n) \quad \text{Formula 5}$$

G is an amplification gain of the PA.

The signal r(n) may be represented as Formula 6.

$$r(n) = f(\mathbf{Ua}) \quad \text{Formula 6}$$

r(n)=f(**Ua**) Formula 6

U is a kernel function matrix including u(n), and $f(\cdot)$ is a nonlinear function of an equivalent PA corresponding to the plurality of PAs. a is a to-be-calculated DPD coefficient.

According to Formula 5, a cost function of Formula 7 is minimized, to calculate a.

$$J = \|\mathbf{e}\|_2^2 = \left\|\frac{\mathbf{r}}{G} - \boldsymbol{u}\right\|_2^2 \quad \text{Formula 7}$$

e represents an error between r and u. r is a vector including r(n) corresponding to a plurality of values of n, and u is a vector including u(n) corresponding to a plurality of values of n. $\|\mathbf{e}\|_2^2$ represents taking a square of a two-norm of **e**. $\left\|\frac{\mathbf{r}}{G} - \boldsymbol{u}\right\|_2^2$ represents taking a square of a two-norm of $\frac{\mathbf{r}}{G} - \boldsymbol{u}$.

Specifically, the second communication apparatus may calculate a according to Formula 5 and the second-order Newton algorithm. Then, the second communication apparatus determines the first signal based on the DPD coefficient obtained through calculation. For a specific determining process, refer to the related descriptions of determining the first signal by the second communication apparatus in the foregoing implementation in which the first coefficient information includes the information about the DPD coefficient.

In a possible implementation, the second communication apparatus performs precoding processing on a fourth signal based on a diagonal matrix. Then, the second communication apparatus processes the fourth signal through a first digital channel, to obtain the first signal. The fourth signal carries multi-stream data, and the first signal also carries multi-stream data.

In this implementation, for the fourth signal that carries the multi-stream data, to facilitate the first communication apparatus to perform stream-by-stream nonlinear model training after channel equalization, and prevent an increase in processing complexity caused by inter-stream cross interference, the second communication apparatus may perform precoding processing on the fourth signal based on the diagonal matrix, and then process the fourth signal through the first digital channel, to obtain the first signal. The first communication apparatus can determine an equalized signal without learning of the diagonal matrix.

In another possible implementation, the second communication apparatus performs precoding processing on a fourth signal based on a non-diagonal matrix. Then, the second communication apparatus processes the fourth signal through a first digital channel, to obtain the first signal. The fourth signal carries multi-stream data, and the first signal also carries multi-stream data.

Optionally, the first communication apparatus is a terminal device, and the second communication apparatus is a network device. The network device sends indication information to the terminal device, where the indication information indicates the non-diagonal matrix.

For example, the fourth signal carries two streams of data, each stream of data is represented as $d_i$, a signal before the PA corresponding to this stream of data is represented as $x_i$, and a signal after the PA corresponding to this stream of data is represented as $s_i$. A signal obtained after the first communication apparatus performs channel equalization is represented as $t_i$. Therefore, it can be learned that $\begin{bmatrix} x_1 \\ x_2 \end{bmatrix} = W \begin{bmatrix} d_1 \\ d_2 \end{bmatrix}$, where $x_1$ is a signal before the PA corresponding to a first stream of data in the two streams of data, $x_2$ is a signal before the PA corresponding to a second stream of data in the two streams of data, the non-diagonal matrix $W = \begin{bmatrix} w_{11} & w_{12} \\ w_{21} & w_{22} \end{bmatrix}$, $d_1$ is the first stream of data in the two streams of data, and $d_2$ is the second stream of data in the two streams of data. When the equivalent PA function corresponding to the two streams of data is $f_i(\cdot)$, the following may be obtained:

$$\begin{bmatrix} t_1 \\ t_2 \end{bmatrix} = \mathbf{W}^{-1} \begin{bmatrix} f_1(x_1) \\ f_2(x_2) \end{bmatrix} = \mathbf{W}^{-1} \begin{bmatrix} f_1(w_{11}d_1 + w_{12}d_2) \\ f_2(w_{21}d_1 + w_{22}d_2) \end{bmatrix}$$

Therefore, the second communication apparatus can restore the equalized signal to $[f_1(w_{11}d_1 + w_{12}d_2)\ f_2(w_{21}d_1 + w_{22}d_2)]^T$ only after obtaining $W$.

1002: The first communication apparatus determines a performance indicator of the first signal.

The performance indicator of the first signal includes at least one of the following: an error vector magnitude, a signal to interference plus noise ratio, a signal-to-noise ratio, a supportable modulation and coding scheme, a channel quality indicator, a supportable highest modulation order, a mean squared error, a normalized mean squared error, or an adjacent channel leakage ratio of the first signal.

It can be learned from step 1001 that the first signal is a signal obtained by performing nonlinear compensation based on the first coefficient information. Therefore, the performance indicator of the first signal may be briefly referred to as a performance indicator of a signal obtained after nonlinear compensation.

1003: The first communication apparatus sends first performance indicator information to the second communication apparatus. The first performance indicator information is determined based on the performance indicator of the first signal. Correspondingly, the second communication apparatus receives the first performance indicator information from the first communication apparatus.

The following describes two possible implementations of the first performance indicator information.

Implementation 1: The first performance indicator information includes the performance indicator of the first signal.

Implementation 2: The first performance indicator information is determined based on the performance indicator of the first signal and a performance indicator of a second signal. The second signal is a signal that is sent by the second communication apparatus to the first communication apparatus and on which nonlinear compensation is not performed. In other words, the performance indicator of the second signal may be briefly referred to as a performance indicator of a signal obtained before nonlinear compensation.

The following describes some possible forms of the first performance indicator information based on Implementation 2.

1. The first performance indicator information includes the performance indicator of the first signal and the performance indicator of the second signal.
2. The first performance indicator information includes the performance indicator of the first signal and a variation between the performance indicator of the first signal and the performance indicator of the second signal.
3. The first performance indicator information includes the performance indicator of the second signal and a variation between the performance indicator of the first signal and the performance indicator of the second signal.

Optionally, the variation between the performance indicator of the first signal and the performance indicator of the second signal includes at least one of the following:
a variation between the error vector magnitude of the first signal and an error vector magnitude of the second signal; a variation between the signal-to-noise ratio of the first signal and a signal-to-noise ratio of the second signal; a variation between the channel quality indicator of the first signal and a channel quality indicator of the second signal; a variation between the mean squared error of the first signal and a mean squared error of the second signal; or a variation between the normalized mean squared error of the first signal and a normalized mean squared error of the second signal.

It should be noted that the variation shown above may be an increment or a decrement, and is specifically determined with reference to an actual calculation result.

Optionally, the embodiment shown in FIG. 10 further includes step 1001a, and step 1001a may be performed before step 1001.

1001a: The second communication apparatus sends first configuration information to the first communication apparatus. The first configuration information indicates the first communication apparatus to report a reporting configuration of the first performance indicator information. Correspondingly, the first communication apparatus receives the first configuration information from the second communication apparatus.

Optionally, the reporting configuration includes a performance indicator that the second communication apparatus requests the first communication apparatus to report. For example, the first configuration information is used by the second communication apparatus to request the first communication apparatus to report the performance indicator of the first signal and the variation between the performance indicator of the first signal and the performance indicator of the second signal.

Based on step 1001a, optionally, step 1003 specifically includes: The first communication apparatus sends the first performance indicator information to the second communication apparatus based on the reporting configuration.

It should be noted that, if the first performance indicator information includes the performance indicator of the first signal, step 1001a may be performed before step 1001. If the first performance indicator information includes the performance indicator of the first signal and the performance indicator of the second signal, or the first performance indicator information includes the performance indicator of the first signal and the variation between the performance

EP 4 590 014 A1



indicator of the first signal and the performance indicator of the second signal, or the first performance indicator information includes the performance indicator of the second signal and the variation between the performance indicator of the first signal and the performance indicator of the second signal, step 1001a may be performed before step 1001b.

Optionally, the embodiment shown in FIG. 10 further includes step 1004, and step 1004 may be performed after step 1002.

1004: The first communication apparatus sends, to the second communication apparatus, first time-frequency resource information associated with the first performance indicator information. Correspondingly, the second communication apparatus receives the first time-frequency resource information from the first communication apparatus.

In a possible implementation, the first time-frequency resource information includes location information of a first time-frequency resource used by the first communication apparatus to receive the first signal. The first performance indicator information is determined by the first communication apparatus based on the first signal received by the first communication apparatus on the first time-frequency resource. In other words, the first performance indicator information is determined based on the performance indicator of the first signal.

In another possible implementation, the first time-frequency resource information includes location information of a first time-frequency resource used by the first communication apparatus to receive the first signal and location information of a second time-frequency resource used by the first communication apparatus to receive the second signal. The first performance indicator information is determined by the first communication apparatus based on the first signal received by the first communication apparatus on the first time-frequency resource and the second signal received by the first communication apparatus on the second time-frequency resource. In other words, the second performance indicator information is determined based on the performance indicator of the first signal and the performance indicator of the second signal.

It should be noted that the first performance indicator information in step 1003 and the first time-frequency resource information in step 1004 may be sent simultaneously or separately. This is not specifically limited in this application. If the first performance indicator information and the first time-frequency resource information are separately sent, there is no fixed execution sequence between step 1003 and step 1004. Step 1003 may be performed before step 1004, or step 1004 may be performed before step 1003. This is not specifically limited in this application.

It can be learned that the first signal is a signal obtained by performing nonlinear compensation based on the first coefficient information. Generally, the first coefficient information may improve linearity of the first signal sent by the second communication apparatus or increase transmit power at which the second communication apparatus transmits the first signal. However, due to some non-ideal factors, the first coefficient information may be inaccurate. For example, a factor such as channel quality deterioration may cause a relatively large error in the first coefficient information.

The following uses the error vector magnitude as an example to describe impact of the first coefficient information on an error vector magnitude of a signal and transmit power of a transmitted signal of the second communication apparatus.

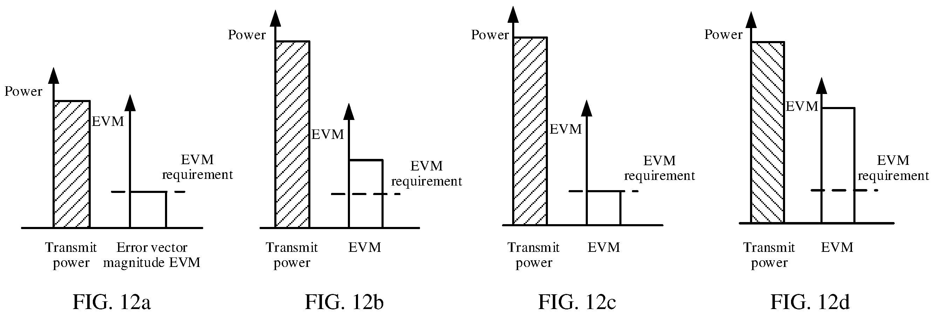

As shown in FIG. 12a, the second communication apparatus sets the transmit power on the premise that the error vector magnitude of the signal is satisfied. It should be noted that, in FIG. 12a, nonlinear compensation is not performed on the to-be-transmitted signal of the second communication apparatus, that is, the second communication apparatus performs PA processing on the to-be-transmitted signal and then transmits the to-be-transmitted signal.

As shown in FIG. 12b, the second communication apparatus directly increases the transmit power of the transmitted signal. It can be learned from FIG. 12b that the error vector magnitude of the signal transmitted by the second communication apparatus is relatively large, and therefore performance of the error vector magnitude deteriorates. It should be noted that, in FIG. 12b, nonlinear compensation is not performed on the to-be-transmitted signal of the second communication apparatus.

As shown in FIG. 12c, the second communication apparatus performs nonlinear compensation on the to-be-transmitted signal by using a proper DPD coefficient, and transmits a signal that is processed by the PA. The second communication apparatus increases the transmit power of the PA on the premise that an error vector magnitude requirement is met. It can be learned from FIG. 12c that the error vector magnitude of the signal transmitted by the second communication apparatus meets the requirement, so that the transmit power of the PA is increased while the error vector magnitude requirement is ensured, thereby increasing a transmission distance of the second communication apparatus.

As shown in FIG. 12d, the second communication apparatus performs nonlinear compensation on the to-be-transmitted signal by using an incorrect DPD coefficient, and transmits a signal that is processed by the PA. The second communication apparatus increases the transmit power of the PA on the premise that an error vector magnitude requirement is met. As shown in FIG. 12d, the error vector magnitude of the signal transmitted by the second communication apparatus is relatively large, and therefore performance of the error vector magnitude deteriorates.

It can be learned from the foregoing analysis that the second communication apparatus may determine, by using the first performance indicator information in step 1003, a nonlinear compensation status of the first coefficient information for the first signal. This prevents performance of the second communication apparatus and communication transmission performance from being affected because the second communication apparatus still uses the first coefficient information to perform nonlinear compensation on a data signal when the first coefficient information has a relatively large error. If the second communication apparatus determines that the performance indicator of the first signal that is fed back by the first communication apparatus is abnormal, the second communication apparatus may select another communication apparatus to perform DPD coefficient training again. Alternatively, the second communication apparatus may select a higher backoff value to perform DPD coefficient training.

In embodiments of this application, the first communication apparatus may report the first performance indicator information to the second communication apparatus. The first performance indicator information is determined based on the performance indicator of the first signal, and the first signal is a signal obtained by performing nonlinear compensation based on the first coefficient information. Therefore, the second communication apparatus may determine a nonlinear compensation status of the first coefficient information for the PA and a benefit brought by the first coefficient information to performance of the second communication apparatus. In this way, the second communication apparatus can accurately determine transmit power or a backoff value of the PA, to implement higher transmit power or better signal sending quality, thereby improving linearity of the equivalent PA, improving linearity of an output signal, enhancing a beam coverage capability, and finally improving a coverage area, a capacity, and the like of the second communication apparatus. This helps avoid problems such as performance deterioration of the second communication apparatus caused by improper coefficient information used by a network device.

In embodiments, the second communication apparatus may obtain the first coefficient information. The following describes two possible obtaining manners.

The following describes a first obtaining manner with reference to step 1001b to step 1001d.

Optionally, the embodiment shown in FIG. 10 further includes step 1001b to step 1001d. Step 1001b to step 1001d may be performed before step 1001.

1001b: The second communication apparatus sends the second signal to the first communication apparatus. The second signal is a signal on which nonlinear compensation is not performed. Correspondingly, the first communication apparatus receives the second signal from the second communication apparatus.

Optionally, the second signal is a reference signal. For the reference signal, refer to the foregoing related descriptions in the configuration information of the reference signal.

Specifically, the second communication apparatus may send the second signal to the first communication apparatus by using a second resource. The second resource corresponds to a first antenna port, and the first antenna port corresponds to a digital channel 1. The digital channel 1 corresponds to a plurality of PAs. That is, the second signal is sent by using the first antenna port, or it may be understood that the second communication apparatus may process the second signal by using a DAC, a plurality of phase shifters, and a plurality of PAs that correspond to the digital channel, and obtain a processed second signal by using a plurality of transmit antennas corresponding to the digital channel 1. It should be noted that DPD processing corresponding to the digital channel 1 is not performed on the second signal. That is, nonlinear compensation is not performed on the second signal. For the second resource, refer to the following related descriptions.

1001c: The first communication apparatus determines the first coefficient information based on the second signal.

The first coefficient information includes information about a DPD coefficient or information about an equivalent PA coefficient.

The following describes a process in which the first communication apparatus determines the information about the DPD coefficient based on the second signal.

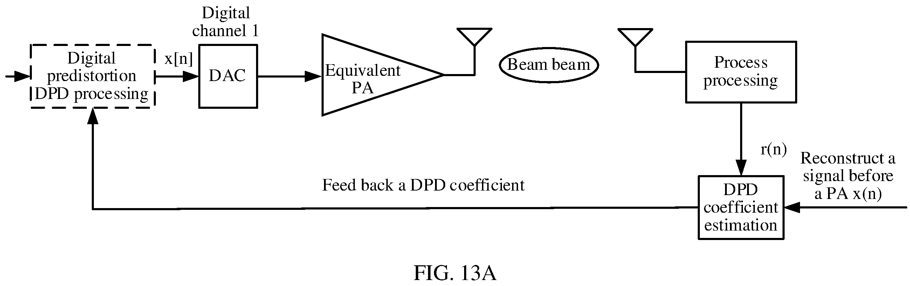

The first communication apparatus determines a DPD model order, a DPD model type, and a DPD model bandwidth. Optionally, the first communication apparatus may specifically determine the DPD model order, the DPD model type, and the DPD model bandwidth by using the following third configuration information. For details, refer to the following related descriptions. Specifically, as shown in FIG. 7, the first communication apparatus reconstructs a signal before the PA x(n). The second signal received by the first communication apparatus is represented as r(n) (also referred to as a signal after the PA). A quantity of sampling points of the second signal is N. The first communication apparatus determines, based on the third configuration information, that the second communication apparatus configures a memory polynomial model and a DPD model order (which specifically includes a highest nonlinear order k and a memory depth m) for the first digital channel. It can be learned from the foregoing related descriptions of FIG. 7 that nonlinear characteristics of one or more PAs corresponding to the first digital channel may be considered as nonlinear characteristics of the equivalent PA, which is specifically shown in FIG. 13A. Therefore, x(n) may be represented as:

$$x(n) = \sum_{k=1}^{K} \sum_{m=0}^{M-1} c_{k,m} |r(n-m)|^{k-1} r(n-m) \quad \text{Formula 8}$$

K is the highest nonlinear order, and M is the memory depth. $c_{k,m}$ is the to-be-estimated DPD parameter. $c_{k,m}$ may be represented by using a vector, and is specifically c = $[c_{1,0}, c_{2,0}, \cdots, c_{K,(M-1)}]^T$, a polynomial kernel function is $\phi_{km}(r) = |r(n-m)|^{k-1}r(n-m)$, signals received by the first communication apparatus at different moments on the second resource are represented by using a matrix R, and R = $[\phi_{10}(\mathbf{r}), \phi_{20}(\mathbf{r}), \cdots, \phi_{K(M-1)}(\mathbf{r})]$. The signal before the PA may be represented as x = $[x(n), x(n+1), \cdots x(n+N-1)]^T$. The signal after the PA is r = $[r(n), r(n+1), \cdots r(n+N-1)]^T$. The first communication apparatus estimates the DPD parameter by using a least square (least square, LS) method. It should be noted that the first communication apparatus may alternatively estimate the DPD parameter by using an iterative algorithm such as a least mean square (least mean square, LMS) algorithm or a recursive least square (recursive least square, RLS) algorithm. This is not specifically limited in this application. The DPD parameter obtained by the first communication apparatus through estimation is represented as c':

$$\mathbf{c}' = \arg\min_{\mathbf{c}} \|\mathbf{x} - \mathbf{Rc}\|_2^2 = (\mathbf{R}^H \mathbf{R})^{-1} \mathbf{R}^H \mathbf{x} \quad \text{Formula 9}$$

$\arg\min_{\mathbf{c}} \|\mathbf{x} - \mathbf{Rc}\|_2^2$ represents taking a minimum value of $\|\mathbf{x} - \mathbf{Rc}\|_2^2$, $\|\mathbf{x} - \mathbf{Rc}\|_2^2$ represents a square of a two-norm of (x - Rc), and $\mathbf{R}^H$ represents a conjugate transposition of the matrix R.

The following describes a process in which the second communication apparatus determines the information about the equivalent PA coefficient based on the second signal.

Specifically, as shown in FIG. 7, the first communication apparatus reconstructs a signal before the PA x(n). The second signal received by the first communication apparatus is represented as r(n) (also referred to as a signal after the PA). A quantity of sampling points of the second signal is N. The first communication apparatus determines, based on the third configuration information, that the second communication apparatus configures a memory polynomial model and a DPD model order (which specifically includes a highest nonlinear order k and a memory depth m) for the first digital channel. It can be learned from the foregoing related descriptions of FIG. 7 that nonlinear characteristics of one or more PAs corresponding to the first digital channel may be considered as nonlinear characteristics of the equivalent PA, which is specifically shown in FIG. 13A. Therefore, r(n) may be represented as:

$$r[n] = \sum_{k=1}^{K} \sum_{m=0}^{M-1} b_{k,m} |x[n-m]|^{k-1} x[n-m] \quad \text{Formula 10}$$

K is the highest nonlinear order, and M is the memory depth. $b_{k,m}$ a is the to-be-calculated equivalent PA coefficient. $b_{k,m}$ may be represented by using a vector, and is specifically b = $(b_{1,0}, b_{2,0}, \cdots, b_{K,(M-1)})^T$. A polynomial kernel function is $\phi_{km}(x) = |x[n-m]|^{k-1}x[n-m]$, and signals sent by the second communication apparatus at different moments on the second resource are represented by using a matrix X. X=$[\phi_{10}(x), \phi_{20}(x), \cdots, \phi_{K(M-1)}(x)]$. The signal after the PA may be represented as r = $[r(n), r(n+1), \cdots r(n+N-1)]^T$. The equivalent PA coefficient obtained by the first communication apparatus through estimation is represented as $\hat{\mathbf{b}}$:

$$\hat{\mathbf{b}} = \arg\min_{\mathbf{b}} \|\mathbf{r} - \mathbf{Xb}\|_2^2 = (\mathbf{X}^H \mathbf{X})^{-1} \mathbf{X}^H \mathbf{r} \quad \text{Formula 11}$$

$\arg\min_{\mathbf{c}} \|\mathbf{r} - \mathbf{Xb}\|_2^2$ represents taking a minimum value of $\|\mathbf{r} - \mathbf{Xb}\|_2^2$, $\|\mathbf{r} - \mathbf{Xb}\|_2^2$ represents a square of a two-norm of (r - Xb), and $\mathbf{X}^H$ represents a conjugate transposition of the matrix X.

The following describes a possible implementation in which the first communication apparatus reconstructs the signal before the PA.

Specifically, the second communication apparatus sends first information to the first communication apparatus. The first information is used by the first communication apparatus to reconstruct the signal before the PA. The first communication apparatus receives the first information from the second communication apparatus.

In a possible implementation, the first communication apparatus reconstructs the signal before the PA based on a predetermined signal sequence and the first information. The predetermined signal sequence may be pre-agreed on by the first communication apparatus and the second communication apparatus, or may be defined in a communication protocol. This is not specifically limited in this application.

In another possible implementation, the first communication apparatus determines, based on fourth configuration information and the first information, to reconstruct the signal before the PA. Specifically, the second communication apparatus sends the fourth configuration information to the first communication apparatus. The fourth configuration information includes information such as a type and a length of a signal sequence used to generate the second signal. The first communication apparatus determines the signal sequence based on the fourth configuration information, and then reconstructs the signal before the PA based on the signal sequence and the first information.

Optionally, the first information indicates at least one of the following: a filter type, a filter coefficient, and inverse fast Fourier transform (inverse fast Fourier transform, IFFT) processing that are used by the second communication apparatus to generate the signal before the PA.

It should be noted that the foregoing are two possible implementations of reconstructing the signal before the PA by the first communication apparatus. During actual application, the first communication apparatus may alternatively reconstruct the signal before the PA based on the second signal received on the second resource. This is not specifically limited in this application.

It should be noted that, optionally, the second communication apparatus generates the signal before the PA, and the signal before the PA is not processed through a crest factor reduction (crest factor reduction, CFR) operation.

For example, as shown in FIG. 5, the second communication apparatus performs IFFT processing on a baseband signal, and then performs filter processing on the baseband signal to obtain the signal before the PA. Before the second communication apparatus generates the signal before the PA, the CFR operation and the DPD processing are not performed. Usually, a filtered signal undergoes the CFR operation to reduce a peak-to-average power ratio (peak-to-average power ratio, PAPR) of the signal. However, this also causes signal distortion, and consequently, it is difficult to reconstruct the signal before the PA. Therefore, the second communication apparatus does not further perform the CFR operation on the baseband signal. In this case, the first communication apparatus may reconstruct the signal before the PA based on the first information and the predetermined signal sequence. For example, the first communication apparatus generates the signal sequence. Then, the first communication apparatus places the signal sequence at a frequency domain position corresponding to the second resource, and performs the IFFT processing to obtain a time domain symbol. Then, the first communication apparatus performs discrete Fourier transform processing on the time domain symbol. The first communication apparatus filters, by using a filter, the signal on which the discrete Fourier transform processing is performed, to obtain the signal before the PA.

It should be noted that the foregoing describes, by using FIG. 5, a process in which the second communication apparatus generates the signal before the PA. FIG. 5 is merely an example. During actual application, in addition to the processing operation shown in FIG. 5, the second communication apparatus may further obtain the signal before the PA with reference to another processing operation. This is not specifically limited in this application.

Optionally, the first communication apparatus may further determine the performance indicator of the second signal, so that the first communication apparatus determines the first performance indicator information with reference to the performance indicator of the first signal and the performance indicator of the second signal.

1001d: The first communication apparatus sends the first coefficient information to the second communication apparatus. Correspondingly, the second communication apparatus receives the first coefficient information from the first communication apparatus.

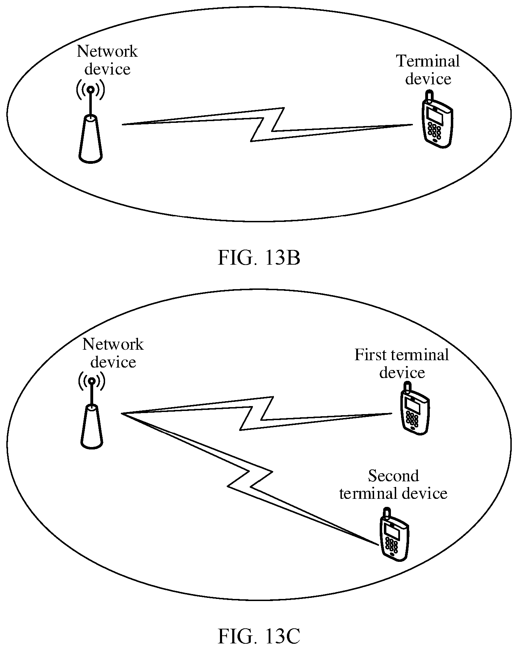

Therefore, as shown in FIG. 13B, the first communication apparatus may be a terminal device, and the second communication apparatus may be a network device. The network device obtains the first coefficient information and the first performance indicator information by using a same terminal device.

The following describes a second obtaining manner with reference to step 1001e to step 1001g.

1001e: The second communication apparatus sends a third signal to a third communication apparatus. The third signal is a signal on which nonlinear compensation is not performed. Correspondingly, the third communication apparatus receives the third signal from the second communication apparatus.

It should be noted that the third signal and the second signal may be a same signal, or may be two different signals. This is not specifically limited in this application.

1001f: The third communication apparatus determines the first coefficient information based on the third signal.

Step 1001f is similar to step 1001c. For details, refer to the related description of step 1001c.

1001g: The third communication apparatus sends the first coefficient information to the second communication apparatus. Correspondingly, the second communication apparatus receives the first coefficient information from the first communication apparatus.

Therefore, as shown in FIG. 13C, the first communication apparatus may be a first terminal device, the second communication apparatus may be a network device, and the third communication apparatus may be a second terminal device. The network device may obtain the first coefficient information by using the second terminal device. The network device obtains the first performance indicator information by using the first terminal device. In this way, the network device can determine a nonlinear compensation status for the first coefficient information, and determine applicability of the first coefficient information to different channels. For example, the first terminal device is located on a first channel, and the second terminal device is located on a second channel. The network device sends the second signal to the second terminal device. The second signal arrives at the second terminal device through the second channel. The second terminal device determines the first coefficient information by using the second signal. The network device sends the first signal to the first terminal device, where the first signal is obtained by performing nonlinear compensation based on the first coefficient information. The first signal arrives at the first terminal device through the first channel. The first terminal device determines the performance indicator of the first signal. If the performance indicator of the first signal meets an actual requirement, it can be learned that the first coefficient information can better compensate for a nonlinear characteristic of the PA, and is applicable to terminal devices on different channels.

Optionally, the embodiment shown in FIG. 10 further includes step 1001h. Step 1001h may be performed before step 1001.

1001h: The second communication apparatus sends indication information to the first communication apparatus. The indication information indicates time-frequency resource information of the first signal. Correspondingly, the first communication apparatus receives the indication information from the second communication apparatus.

In a possible implementation, the indication information indicates time-frequency resource information of the first signal. The time-frequency resource information of the first signal indicates location information of a time-frequency resource used by the second communication apparatus to send the first signal. In this way, the first communication apparatus can receive the first signal on the time-frequency resource used for the first signal. In this implementation, the first performance indicator information includes the performance indicator of the first signal.

In this implementation, step 1001h may be performed before step 1001. There is no fixed execution sequence between step 1001h and step 1001a. Step 1001h may be performed before step 1001a; or step 1001a is performed before step 1001h; or step 1001a and step 1001h are simultaneously performed according to a situation. This is not specifically limited in this application.

In another possible implementation, the indication information indicates time-frequency resource information of the first signal and time-frequency resource information of the second signal. The time-frequency resource information of the first signal indicates location information of a time-frequency resource used by the second communication apparatus to send the first signal. The time-frequency resource information of the second signal indicates location information of a time-frequency resource used by the second communication apparatus to send the second signal. Therefore, the first communication apparatus receives the first signal on the time-frequency resource used for the first signal and receives the second signal on the time-frequency resource used for the second signal.

In this implementation, the first performance indicator information includes the performance indicator of the first signal and the performance indicator of the second signal. Alternatively, the first performance indicator information includes the performance indicator of the first signal and a variation between the performance indicator of the first signal and the performance indicator of the second signal. Alternatively, the first performance indicator information includes the performance indicator of the second signal and a variation between the performance indicator of the first signal and the performance indicator of the second signal.

In this implementation, step 1001h may be performed before step 1001b. There is no fixed execution sequence between step 1001h and step 1001a. Step 1001h may be performed before step 1001a; or step 1001a is performed before step 1001h; or step 1001a and step 1001h are simultaneously performed according to a situation. This is not specifically limited in this application.

Optionally, the embodiment shown in FIG. 10 further includes step 1001i, and step 1001i may be performed before step 1001.

1001i: The second communication apparatus sends second configuration information to the first communication apparatus. Correspondingly, the first communication apparatus receives the second configuration information from the second communication apparatus.

The second configuration information includes information about a first resource. The first resource corresponds to a first antenna port. In other words, the first resource corresponds to the first antenna port of the second communication apparatus. The first antenna port corresponds to the first digital channel. The first digital channel corresponds to one or more PAs.

For example, as shown in FIG. 5, the first digital channel is a digital channel 1, and the digital channel 1 corresponds to a plurality of PAs. The second communication apparatus may send the first signal to the first communication apparatus by using the first resource. The first resource includes the first antenna port corresponding to the first resource, which means that the first signal is sent through the first antenna port. It may also be understood that the second communication apparatus may process the first signal by using DPD corresponding to the digital channel 1, and a DAC, a plurality of phase shifters, and a plurality of PAs that correspond to the digital channel 1, and send a processed first signal by using a plurality of transmit antennas corresponding to the digital channel 1.

Optionally, the first resource may be a periodic resource or a semi-persistent resource. This is not specifically limited in this application. In this implementation, from a perspective of time domain, the second communication apparatus may select to periodically send the first signal. This helps prevent data from being discarded or retransmission caused by severe interference to a signal at some moments, and also helps the first communication apparatus perform cross validation on performance indicators of the first signal by using first signals sent at different moments.

Optionally, the first resource may be a DMRS resource or a CSI-RS resource.

Optionally, the first resource may include one or more measurement resources. Each of the one or more measurement resources may occupy one or more time domain symbols in time domain. Each of the plurality of measurement resources occupies a channel bandwidth of a to-be-transmitted data signal in frequency domain. In this implementation, each measurement resource occupies the channel bandwidth of the to-be-transmitted data signal in frequency domain. This helps the second communication apparatus send the first signal in an entire channel bandwidth, and helps the first communication apparatus obtain information about a DPD coefficient of the first digital channel in the entire channel bandwidth.

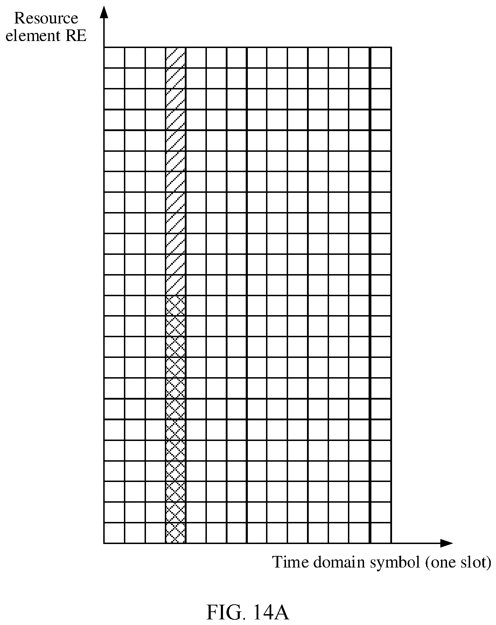

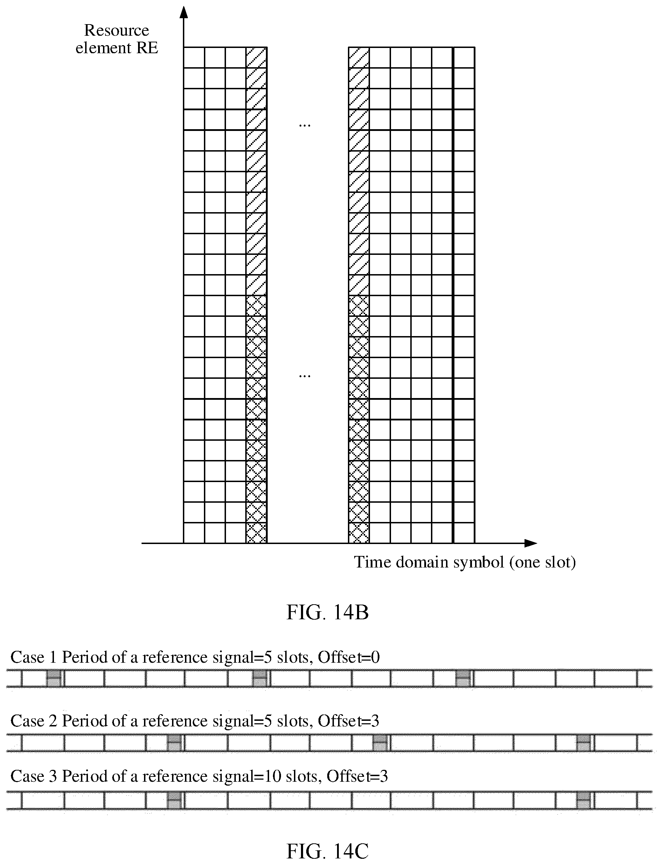

For example, as shown in FIG. 14A, one measurement resource occupies one time domain symbol in time domain, and occupies a plurality of resource elements (resource elements, REs) in frequency domain. As shown in FIG. 14B, one measurement resource occupies a plurality of time domain symbols in time domain, and occupies a plurality of REs in frequency domain.

It should be noted that a quantity of time domain symbols occupied by each measurement resource may be determined in consideration of at least one of the following factors: a quantity of fast Fourier transform (fast Fourier transform, FFT) points used when the first communication apparatus performs signal sampling, complexity of training the DPD coefficient by the first communication apparatus, and a requirement setting of DPD coefficient compensation performance.

For example, when there are a large quantity of FFT points, each measurement resource may occupy one time domain symbol. When there are a small quantity of FFT points, each measurement resource may occupy a plurality of time domain symbols, to ensure DPD coefficient training performance.

It should be noted that, when each measurement resource occupies a plurality of time domain symbols, the plurality of time domain symbols may be consecutive or inconsecutive. This is not specifically limited in this application. In a scenario in which the plurality of time domain symbols are consecutive, it is convenient for the first communication apparatus to perform signal sampling and obtain the DPD coefficient.

Optionally, when the first resource includes a plurality of measurement resources, sending periods and slot offsets of the first signal may be the same or may be different.

For example, as shown in FIG. 14C, in case 1, a sending period of the first signal is five slots, and a slot offset of the first signal is 0. In case 2, a sending period of the first signal is five slots, and a slot offset of the first signal is 3. In case 3, a sending period of the first signal is 10 slots, and a slot offset of the first signal is 3.

Optionally, the second configuration information further includes information about a second resource. The second resource corresponds to a first antenna port. In other words, the second resource corresponds to the first antenna port of the second communication apparatus.

For example, as shown in FIG. 5, the first digital channel is a digital channel 1, and the digital channel 1 corresponds to a plurality of PAs. The second communication apparatus may send the second signal to the first communication apparatus by using a second resource. The second resource includes the first antenna port corresponding to the second resource, which means that the second signal is sent through the first antenna port. It may also be understood that the second communication apparatus may process the second signal by using a DAC, a plurality of phase shifters, and a plurality of PAs that correspond to the digital channel 1, and send a processed second signal by using a plurality of transmit antennas corresponding to the digital channel 1. It should be noted that DPD processing corresponding to the digital channel 1 is not performed on the second signal. That is, nonlinear compensation is not performed on the second signal.

Optionally, the second resource is similar to the first resource. For details, refer to the foregoing related descriptions of the first resource.

In a possible implementation, the first configuration information includes information about a first resource. In this implementation, step 1001i may be performed before step 1001.

In another possible implementation, the first configuration information includes information about a first resource and information about a second resource. In this implementation, step 1001i may be performed before step 1001b.

Based on the foregoing two possible implementations, it should be noted that there is no fixed execution sequence between step 1001i, step 1001a, and step 1001h. Specifically, an execution sequence of step 1001i, step 1001a, and step 1001h is not limited in this application. For example, step 1001i may be performed first, then step 1001a is performed, and finally step 1001h is performed. Alternatively, step 1001i is performed first, then step 1001h is performed, and finally step 1001a is performed. Alternatively, step 1001a is performed first, then step 1001i is performed, and finally step 1001h is performed. Alternatively, step 1001i, step 1001a, and step 1001h are performed simultaneously according to a situation.

Optionally, the embodiment shown in FIG. 10 further includes step 1001j, and step 1001j may be performed before step 1001.

1001j: The second communication apparatus sends third configuration information to the first communication apparatus. Correspondingly, the first communication apparatus receives the third configuration information from the second communication apparatus.

The third configuration information is used to configure at least one of the following: a DPD coefficient reporting format, a DPD model type used by the first communication apparatus to calculate a DPD coefficient, a DPD model order, and a DPD model bandwidth.

Optionally, the DPD coefficient model type includes a polynomial model, a memory polynomial model, and a generalized memory polynomial (generalized memory polynomial, GMP) model.

The DPD model order includes at least one of the following: a nonlinear order, a memory depth, and a cross-term length.

Each DPD coefficient model corresponds to a different DPD model order, and is represented by using a model parameter modelParameters = {K M G} below, where K represents a highest nonlinear order, M represents a memory depth, and G represents a cross-term length. The model order needs to match the model type. For the polynomial model, M=G=0. For the memory polynomial model, G=0. For the generalized memory polynomial model, K, M, and G are all not zero.

The following describes expressions of the plurality of models from a perspective of a DPD module corresponding to the first digital channel.

The polynomial model may be represented as Formula 12:

$$x(n) = \sum_{k=0}^{K-1} c_k |r(n)|^k r(n) \ \text{Formula 12}$$

$x(n)$ represents a signal output by the DPD module, $c_k$ is a model coefficient of the polynomial model, and $r(n)$ represents a signal input to the DPD module.

The memory polynomial model may be represented as Formula 13:

$$x(n) = \sum_{k=0}^{K-1} \sum_{m=0}^{M-1} c_{km} |r(n-m)|^k r(n-m) \ \text{Formula 13}$$

$x(n)$ represents a signal output by the DPD module, $c_{km}$ is a model coefficient of the polynomial model, and $r(n-m)$ represents a signal input to the DPD module.

The generalized memory polynomial model may be represented as Formula 14:

$$x(n) = \sum_{k=0}^{K-1} \sum_{m=0}^{M-1} c_{km} |r(n-m)|^k r(n-m)$$
$$+ \sum_{k=0}^{K-1} \sum_{m=0}^{M-1} \sum_{g=1}^{G} \big[ a_{kmg} |r(n-m)|^k r(n-m-g) \ \text{Formula 14}$$
$$+ b_{kmg} |r(n-m)|^k r(n-m+g) \big]$$

$x(n)$ represents a signal output by the DPD module, $c_{km}$, $a_{kmg}$, and $b_{kmg}$ are model coefficients of the generalized memory polynomial model, and $r(n-m)$ represents a signal input to the DPD module.

Optionally, the second communication apparatus may directly indicate the DPD model type to the first communication apparatus. Alternatively, the second communication apparatus may indicate the DPD model order to the first communication apparatus, and indirectly indicate the DPD model type based on the DPD model order.

For example, in the DPD model order indicated by the second communication apparatus to the first communication apparatus, M = G = 0. In this case, the second communication apparatus may determine that the DPD model is the polynomial model. For example, in the DPD model order indicated by the second communication apparatus to the first communication apparatus, G = 0. In this case, the second communication apparatus may determine that the DPD model is the memory polynomial model. For example, in the DPD model order indicated by the second communication apparatus to the first communication apparatus, K, M, and G are all not zero. In this case, the second communication apparatus may determine that the DPD model is the generalized memory polynomial model.

The DPD model bandwidth may be understood as a bandwidth used by the second communication apparatus to send the second signal. For DPD coefficient training performed by the first communication apparatus, the bandwidth used by the second communication apparatus to send the second signal is important information. Because spectrum broadening occurs after the second signal passes through a PA corresponding to a digital channel, a spectrum is usually broadened by three to five times. To provide a training effect of the DPD coefficient, the first communication apparatus needs to fully obtain out-of-band information of each measurement resource. Therefore, a sampling rate and a sampling bandwidth of the first communication apparatus need to meet a specific requirement. However, to control an algorithm and costs, the DPD model bandwidth may be agreed on between the second communication apparatus and the first communication apparatus, and may be specifically indicated by the second communication apparatus to the first communication apparatus by using the second configuration information. For example, a value of the DPD model bandwidth is $30.72e^6 \times [1, 2, 4, 8, 16, 32, 64]$ sps (sample per second, sps)). The second communication apparatus may send the second signal for a plurality of times with reference to the DPD model bandwidth and the sampling bandwidth of the first communication apparatus. In other words, the second resource includes a plurality of measurement resources, and the second communication apparatus sends the second signal by using the plurality of measurement resources. This helps the first communication apparatus obtain in-band information of the measurement resource and out-of-band information of the measurement resource by measuring the second signal for a plurality of times, so that the first communication apparatus determines the DPD coefficient with reference to the in-band information and the out-of-band information.

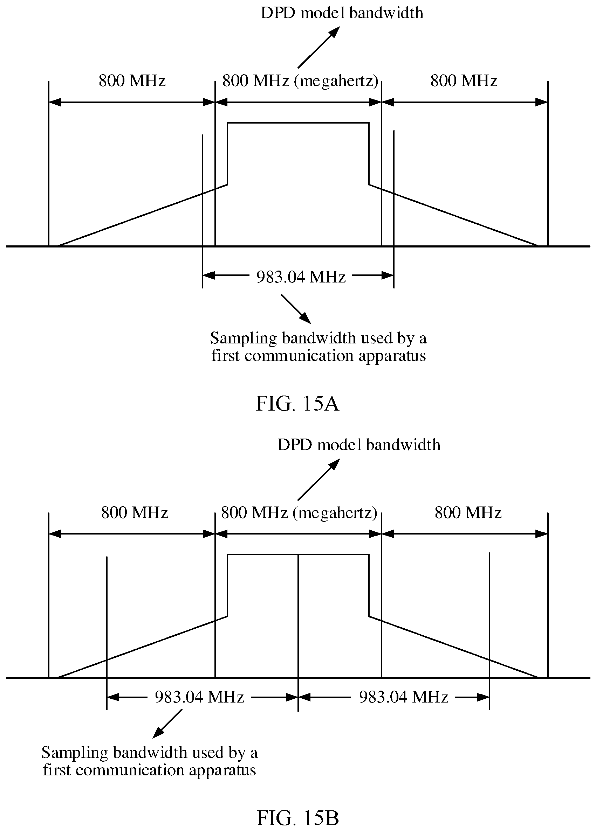

For example, as shown in FIG. 15A, the DPD model bandwidth is 800 MHz (megahertz). The second signal undergoes three to five times spectrum broadening after passing through the PA corresponding to the digital channel. An example in which the second signal undergoes three times spectrum broadening after passing through the PA corresponding to the digital channel is used herein for description. Therefore, the second signal occupies a bandwidth of 2400 MHz. The sampling bandwidth of the first communication apparatus is 983.04 MHz. Therefore, the second communication apparatus may send the second signal for a plurality of times on the 800 MHz DPD model bandwidth. The first communication apparatus may adjust a center frequency for sampling, so that the first communication apparatus performs sampling on a received signal by using different center frequencies, to obtain information about the second signal in 2400 MHz. For example, as shown in FIG. 15B, the second communication apparatus sends the second signal to the first communication apparatus by using one measurement resource in the second resource. The first communication apparatus may set the center frequency to 491.51 MHz. The first communication apparatus performs sampling on the received second signal by using the center frequency 491.51 MHz, to obtain a first sampling signal. The second communication apparatus sends the second signal to the first communication apparatus again by using another measurement resource in the second resource. The first communication apparatus adjusts the center frequency to -491.51 MHz. The first communication apparatus performs sampling on the received second signal by using the center frequency -491.51 MHz, to obtain a second sampling signal. Then, the first communication apparatus combines the first sampling signal and the second sampling signal in frequency domain, to obtain a combined signal. The first communication apparatus determines a DPD coefficient of the first antenna port based on the combined signal.

The DPD coefficient reporting format indicates a reporting requirement for a nonlinear order and a memory depth in the DPD coefficient.

Specifically, the second communication apparatus may indicate a corresponding DPD coefficient reporting format to the first communication apparatus based on nonlinear strength and memory strength of one or more PAs corresponding to the digital channel. For example, stronger nonlinear strength of the one or more PAs corresponding to the digital channel indicates stronger memory strength. In this case, the second communication apparatus may configure the first communication apparatus to report more terms corresponding to both the nonlinear strength and the memory strength in the DPD coefficient. Weaker nonlinear strength of the one or more PAs corresponding to the digital channel indicates weaker memory strength. In this case, the second communication apparatus may configure the first communication apparatus to report fewer terms corresponding to both the nonlinear strength and the memory strength in the DPD coefficient.

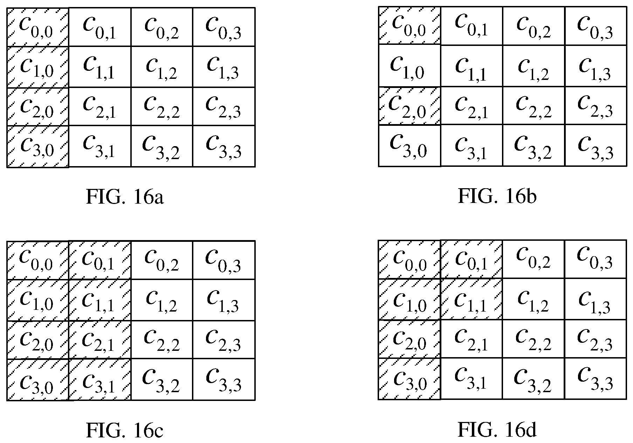

The following describes several possible DPD coefficient reporting formats by using an example in which k is equal to 3 and m is equal to 3 in the memory polynomial model. Specifically, FIG. 16a to FIG. 16d show four possible DPD coefficient reporting patterns. $c_{km}$ represents a DPD coefficient corresponding to a nonlinear order k and a memory depth m.

First, FIG. 16a is used as an example to describe meanings respectively represented by a first column to a fourth column in FIG. 16a and meanings respectively represented by a first row to a fourth row in FIG. 16a. The first column indicates a 0th-order memory depth, that is, a memory depth 0. The second column indicates a first-order memory depth, that is, a memory depth 1. The third column indicates a second-order memory depth, that is, a memory depth 2. The fourth column indicates a fourth-order memory depth, that is, a memory depth 3. The first row indicates first-order nonlinear strength, that is, nonlinear strength 1. The second row indicates second-order nonlinear strength, that is, nonlinear strength 2. The third row indicates third-order nonlinear strength, that is, nonlinear strength 3. The fourth row indicates fourth-order nonlinear strength, that is, nonlinear strength 4. FIG. 16b to FIG. 16d are similar, and details are not described herein.

When the PA corresponding to the digital channel has no memory or has a weak memory, the second communication apparatus may configure a DPD coefficient reporting format shown in FIG. 16a or FIG. 16b. In addition, the DPD coefficient reporting format shown in FIG. 16a indicates that nonlinear strength of the PA corresponding to the digital channel is strong, and a reporting format of full-order nonlinear strength needs to be configured. The DPD coefficient reporting format shown in FIG. 16b indicates that nonlinear strength of the PA corresponding to the digital channel is low, and a reporting format of only two-order nonlinear strength needs to be configured.

When the PA corresponding to the digital channel has a memory, the second communication apparatus may configure a DPD coefficient reporting format shown in FIG. 16c or FIG. 16d. In addition, the DPD coefficient reporting format shown in FIG. 16c indicates that all coefficients of the memory depth 0 and the memory depth 1 are reported. The DPD coefficient reporting format shown in FIG. 16d indicates that not all coefficients of the memory depth 0 and the memory depth 1 are reported. FIG. 16d may be understood as a DPD coefficient reporting format that may be used in a scenario in which the nonlinear strength of the PA corresponding to the digital channel is weak.

It should be noted that the second communication apparatus may configure a corresponding DPD coefficient reporting format for each digital channel. Different digital channels may correspond to different DPD coefficient reporting formats, or different digital channels may correspond to a same DPD coefficient reporting format. This is not specifically limited in this application. During actual application, the second communication apparatus may determine, with reference to the nonlinear strength and the memory depth of the PA corresponding to the digital channel, the DPD coefficient reporting format corresponding to each digital channel.

It can be learned that the second communication apparatus may configure the DPD coefficient reporting format for the first communication apparatus, so that the first communication apparatus reports a part of DPD coefficients with reference to the DPD coefficient reporting format, to reduce system overheads.

Optionally, the second communication apparatus indicates, by using the DPD coefficient reporting format, the first communication apparatus to report odd numbered-order nonlinear strength and an odd numbered-order memory depth; or the second communication apparatus indicates, by using the DPD coefficient reporting format, the first communication apparatus to report odd/even numbered-order nonlinear strength and an odd/even numbered-order memory depth.

Usually, odd numbered-order nonlinear strength and an odd numbered-order memory depth may reflect most nonlinear characteristics of an equivalent PA corresponding to a digital channel. Therefore, the second communication apparatus may indicate the first communication apparatus to report odd-order nonlinear strength and a memory depth. Therefore, system reporting overheads are reduced.

Optionally, the second communication apparatus generates the second configuration information based on at least one of the following factors: a nonlinear characteristic of one or more PAs corresponding to the digital channel, a performance requirement of communication transmission, resource overheads needed for the DPD coefficient training, and overheads for reporting the DPD coefficient. It can be learned that a DPD coefficient reporting format, a DPD model type, and a DPD model order that are configured by the second communication apparatus for each digital channel are associated with each other.

It should be noted that step 1001j shows an implementation in which the second communication apparatus configures related information of DPD reporting by using the third configuration information. During actual application, the information configured by using the third configuration information may alternatively be predefined in a communication protocol. This is not specifically limited in this application.

It should be noted that the second communication apparatus configures corresponding DPD-related information (a DPD coefficient reporting format, a DPD model type, a DPD model order, and a DPD model bandwidth) for each digital channel, and different digital channels may use different DPD-related information. Alternatively, the second communication apparatus configures same DPD-related information for each digital channel. This is not specifically limited in this application. During actual application, the second communication apparatus may configure DPD-related information for each digital channel with reference to the nonlinear characteristic of the one or more PAs corresponding to each digital channel and an actual requirement.

It can be learned that the second communication apparatus may define the DPD-related information such as the DPD model type, the DPD model order, and the DPD model bandwidth for the digital channel. It is ensured that DPD-related information used by a receiving end and DPD-related information used by a transmitting end are unified, so that DPD coefficient training efficiency is improved, and OTA-DPD is more suitable for an actual application scenario.

The embodiment shown in FIG. 10 describes that the first communication apparatus and the second communication apparatus determine the first coefficient information corresponding to the first digital channel and the first performance indicator information corresponding to the first digital channel. During actual application, determining of coefficient information and performance indicator information corresponding to another digital channel is also applicable, and details are not described herein. It should be noted that different digital channels may use different measurement resources, so as to avoid mutual interference between different digital channels or different beam directions when the first communication apparatus trains information about DPD coefficients corresponding to different digital channels, thereby improving DPD training performance. In other words, in the technical solutions of this application, the second communication apparatus may configure measurement resources for digital channels one by one and for beam directions one by one. Different measurement resources occupy different time domain positions, so as to avoid interference between subarrays or beam directions corresponding to different digital channels, and improve a DPD coefficient training effect, thereby ensuring high matching between DPD training and DPD application.

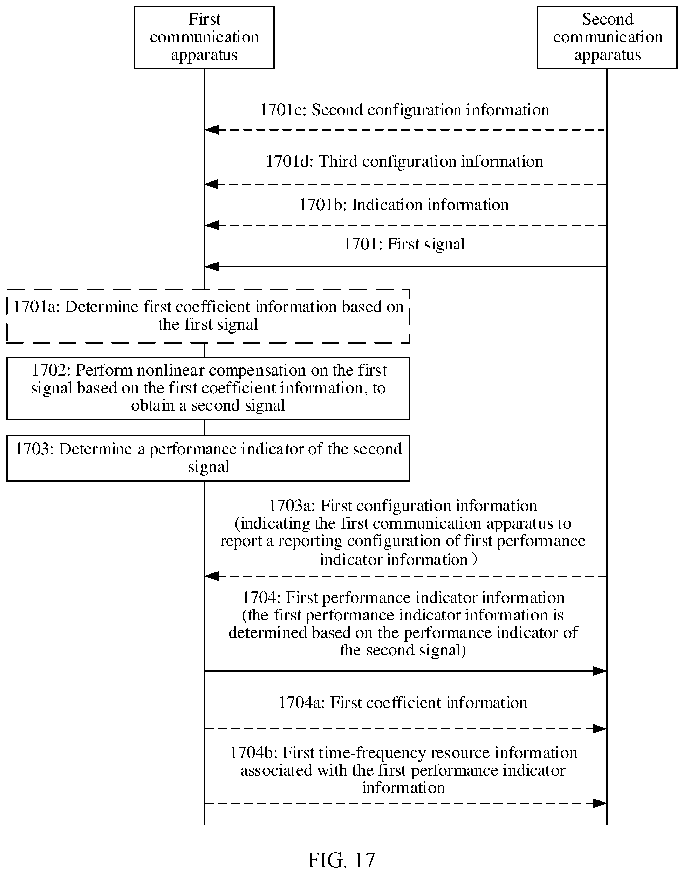

FIG. 17 is a diagram of another embodiment of a communication method according to embodiments of this application. Refer to FIG. 17. The method includes the following steps.

1701: A second communication apparatus sends a first signal to a first communication apparatus. Correspondingly, the first communication apparatus receives the first signal from the second communication apparatus.

The first signal is a signal on which nonlinear compensation is not performed. Optionally, the first signal is a reference signal. For the reference signal, refer to the foregoing related descriptions in the configuration information of the reference signal.

Specifically, the second communication apparatus may send the first signal to the first communication apparatus by using a first resource. Correspondingly, the first communication apparatus receives the first signal from the second communication apparatus by using the first resource. As shown in FIG. 5, the first resource corresponds to a first antenna port, and the first antenna port corresponds to a digital channel 1. The digital channel 1 corresponds to a plurality of PAs. The second communication apparatus may send the first signal to the first communication apparatus by using the first resource. The first resource includes the first antenna port corresponding to the first resource, which means that the first signal is sent through the first antenna port. It may also be understood that the second communication apparatus may process the first signal by using a DAC, a plurality of phase shifters, and a plurality of PAs that correspond to the digital channel 1, and send a processed first signal by using a plurality of transmit antennas corresponding to the digital channel 1. It should be noted that DPD processing corresponding to the digital channel 1 is not performed on the first signal. For the first resource, refer to the following related descriptions.

In a possible implementation, the second communication apparatus performs precoding processing on a third signal based on a diagonal matrix. Then, the second communication apparatus processes the third signal through a first digital channel, to obtain the first signal. The third signal carries multi-stream data, and the first signal also carries multi-stream data. The third signal is obtained by performing processing such as layer mapping on a reference signal sequence. The reference sequence may be a DMRS sequence or a CSI-RS sequence.

In this implementation, for the third signal that carries the multi-stream data, to facilitate the first communication apparatus to perform stream-by-stream nonlinear model training after channel equalization, and prevent an increase in processing complexity caused by inter-stream cross interference, the second communication apparatus may perform precoding processing on the third signal based on the diagonal matrix, and then process the third signal through the first digital channel, to obtain the first signal. The first apparatus can determine an equalized signal without learning of the diagonal matrix.

In another possible implementation, the second communication apparatus performs precoding processing on a third signal based on a non-diagonal matrix. Then, the second communication apparatus processes the third signal through a first digital channel, to obtain the first signal. The third signal carries multi-stream data, and the first signal also carries multi-stream data. Optionally, the first communication apparatus is a terminal device, and the second communication apparatus is a network device. The network device sends indication information to the terminal device, where the indication information indicates the non-diagonal matrix.

A process in which the second communication apparatus obtains the channel equalized signal through parsing is similar to the process in which the second communication apparatus determines the equalized signal in step 1001 in the embodiment shown in FIG. 10. For details, refer to the related descriptions in step 1001 in the embodiment shown in FIG. 10.

1702: The first communication apparatus performs nonlinear compensation on the first signal based on first coefficient information, to obtain a second signal.

The first coefficient information includes information about a DPD coefficient or information about an equivalent PA coefficient.

Specifically, the first communication apparatus performs channel equalization on the first signal to obtain a signal after the PA. Then, the first communication apparatus performs nonlinear compensation on the signal after the PA based on the first coefficient information, to obtain the second signal.

1703: The first communication apparatus determines a performance indicator of the second signal.

The performance indicator of the second signal is similar to the performance indicator of the first signal in step 1002 in the embodiment shown in FIG. 10. For details, refer to the related descriptions of step 1002 in the embodiment shown in FIG. 10.

Optionally, the embodiment shown in FIG. 17 further includes step 1703a, and step 1703a may be performed before step 1704.

1703a: The second communication apparatus sends first configuration information to the first communication apparatus. The first configuration information indicates the first communication apparatus to report a reporting configuration of first performance indicator information. Correspondingly, the first communication apparatus receives the first configuration information from the second communication apparatus.

Step 1703a is similar to step 1001a in the embodiment shown in FIG. 10. For details, refer to the related descriptions of step 1001a in the embodiment shown in FIG. 10.

Based on step 1703a, optionally, step 1003 specifically includes: The first communication apparatus sends the first performance indicator information to the second communication apparatus based on the reporting configuration.

It should be noted that there is no fixed execution sequence between step 1703a and step 1701 to step 1703. Step 1703a may be performed before step 1701 to step 1703; or step 1701 to step 1703 are performed before step 1703a; or step 1703a and step 1701 to step 1703 are simultaneously performed according to a situation. This is not specifically limited in this application.

1704: The first communication apparatus sends the first performance indicator information to the second communication apparatus. Correspondingly, the second communication apparatus receives the first performance indicator information from the first communication apparatus.

The first performance indicator information is determined based on the performance indicator of the second signal.

The following describes two possible implementations of the first performance indicator information.

Implementation 1: The first performance indicator information includes the performance indicator of the second signal.

Implementation 2: The first performance indicator information is determined based on a performance indicator of the first signal and the performance indicator of the second signal. It can be learned from step 1701 that the first signal is a signal on which nonlinear compensation is not performed, that is, the performance indicator of the first signal may be referred to as a performance indicator of a signal before the nonlinear compensation.

In the implementation 2, for some possible forms of the first performance indicator information, refer to the related descriptions of step 1002 in the embodiment shown in FIG. 10. Details are not described herein again.

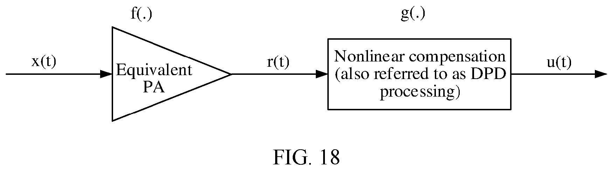

In the technical solutions of embodiments, as shown in FIG. 18, a to-be-transmitted signal of the second communication apparatus is represented as x(t). As shown in FIG. 5, an equivalent function that is of the second communication apparatus and that corresponds to the plurality of PAs corresponding to the digital channel 1 is represented as $f(\cdot)$. Therefore, the second communication apparatus determines that a signal (that is, the first signal) after an equivalent PA is r(t)= $f$(x(t)). A DPD equivalent function corresponding to the DPD coefficient is $g(\cdot)$. Therefore, it can be learned that the second signal may be represented as u(t)=g($f$(x(t))). The second communication apparatus may determine the first performance indicator information by using the first signal r(t) and the second signal u(t).

It can be learned from the foregoing analysis that the second communication apparatus may determine, by using the first performance indicator information in step 1003, a nonlinear compensation status of the first coefficient information for the first signal. This prevents performance of the second communication apparatus and affects communication transmission performance from being affected because the second communication apparatus still uses the first coefficient information to perform nonlinear compensation on a data signal when the first coefficient information has a relatively large error. If the second communication apparatus determines that the performance indicator of the first signal that is fed back by the first communication apparatus is abnormal, the second communication apparatus may select another communication apparatus to perform DPD coefficient training again. Alternatively, the second communication apparatus may select a higher backoff value to perform DPD training.

In embodiments of this application, the first communication apparatus performs nonlinear compensation on the first signal based on the first coefficient information, to obtain the second signal. Then, the first communication apparatus sends the first performance indicator information to the second communication apparatus, where the first performance indicator information is determined based on the performance indicator of the second signal. Therefore, the second communication apparatus may determine a nonlinear compensation status of the first coefficient information for the first signal and a benefit brought by the first coefficient information to performance of the second communication apparatus. In this way, the second communication apparatus can accurately determine transmit power or a backoff value of the PA, to implement higher transmit power or better signal sending quality, improve linearity of a signal output by the second communication apparatus, and finally improve a coverage area, a capacity, and the like of the second communication apparatus. This helps avoid problems such as performance deterioration of the second communication apparatus caused by improper coefficient information used by a network device.

Optionally, the embodiment shown in FIG. 17 further includes step 1701a to step 1704a. Step 1701a to step 1704a may be performed after step 1701.

1701a: The first communication apparatus determines the first coefficient information based on the first signal.

Step 1701a is similar to step 1001c in the embodiment shown in FIG. 10. For details, refer to the related descriptions of step 1001c in the embodiment shown in FIG. 10. Details are not described herein again.

1704a: The first communication apparatus sends the first coefficient information to the second communication apparatus. Correspondingly, the second communication apparatus receives the first coefficient information from the first communication apparatus.

In this implementation, the first communication apparatus may report the first coefficient information to the second communication apparatus, so that the second communication apparatus determines, based on the first performance indicator information, the performance indicator of the second signal obtained by performing nonlinear compensation by using the first coefficient information. Therefore, the second communication apparatus may determine a nonlinear compensation status of the first coefficient information for the PA.

It should be noted that there is no fixed execution sequence between step 1704a and step 1704. Step 1704a may be performed before step 1704; or step 1704 is performed before step 1704a; or step 1704a and step 1704 are simultaneously performed according to a situation. This is not specifically limited in this application.

Optionally, the first communication apparatus may further report the DPD coefficient in the first coefficient information based on a DPD coefficient reporting format. This helps reduce reporting overheads. The DPD coefficient reporting format may be configured by the second communication apparatus for the first communication apparatus, or may be agreed on in a communication protocol. This is not specifically limited in this application. For an example of the DPD coefficient reporting format, refer to the related descriptions in FIG. 16a to FIG. 16d.

The following describes some possible implementations in which the first communication apparatus obtains the first coefficient information and the first performance indicator information, and the first communication apparatus reports the first coefficient information and the first performance indicator information.

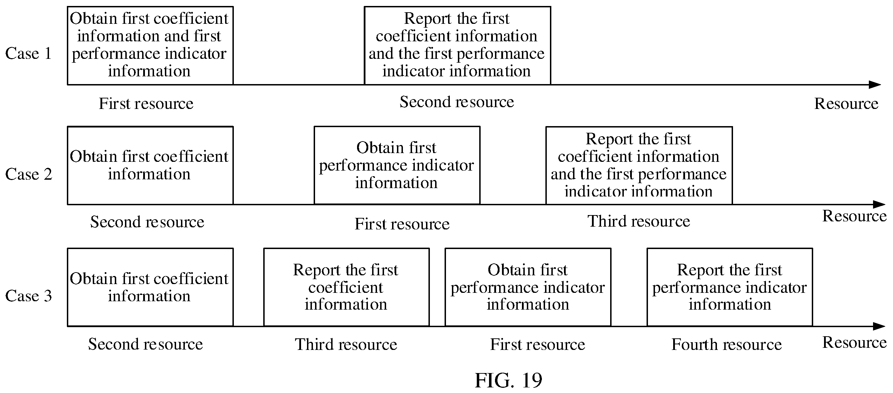

As shown in FIG. 19, in case 1, the first communication apparatus determines the first coefficient information and the first performance indicator information by using signals on a same resource (the first resource). Then, the first communication apparatus sends the first coefficient information and the first performance indicator information to the second communication apparatus by using a second resource. For a specific implementation process of case 1, refer to the related descriptions of the embodiment shown in FIG. 17. In case 1, the first communication apparatus obtains the first coefficient information and the first performance indicator information on a same resource, so as to eliminate impact of external factors such as channel fading and interference, and ensure that the first performance indicator information can accurately reflect a benefit brought by performing nonlinear compensation by using the first coefficient information.

As shown in FIG. 19, in case 2, the first communication apparatus determines the first performance indicator information by using the first signal on the first resource, and determines the first coefficient information by using the signal on the second resource. Then, the first communication apparatus sends the first coefficient information and the first performance indicator information to the second communication apparatus by using a third resource. In case 3, the first communication apparatus determines the first coefficient information by using the signal on the second resource, and sends the first coefficient information to the second communication apparatus by using a third resource. The first communication apparatus determines the first performance indicator information by using the first signal on the first resource, and sends the first performance indicator information to the second communication apparatus by using a fourth resource. In case 2 and case 3, the first communication apparatus separately obtains the first coefficient information and the first performance indicator information on different resources. Therefore, processing complexity of the first communication apparatus is reduced.

Optionally, when the performance indicator of the second signal is abnormal, step 1704a specifically includes: The first communication apparatus sends the first coefficient information to the second communication apparatus based on a first coefficient information reporting format.

The first coefficient information reporting format includes a reporting requirement for a nonlinear order and a memory depth in a DPD coefficient or an equivalent PA coefficient. The first coefficient information reporting format indicates that the performance indicator of the second signal is abnormal.

In an ideal environment, the first coefficient information reported by the first communication apparatus can improve the performance indicator of the second signal, or help the second communication apparatus improve transmit power. However, due to existence of some non-ideal factors, the first communication apparatus may determine that the first coefficient information determined is inaccurate. Therefore, when the first communication apparatus determines that the performance indicator of the second signal is abnormal, the first communication apparatus sends the first coefficient information to the second communication apparatus based on the first coefficient information reporting format. In this way, after obtaining the first coefficient information, the second communication apparatus does not use the first coefficient information to perform nonlinear compensation, thereby preventing performance deterioration of the second communication apparatus from affecting communication transmission performance.

Optionally, that the performance indicator of the second signal is abnormal includes at least one of the following:

1. A difference between an error vector magnitude of the first signal and an error vector magnitude of the second signal is less than a first threshold; or a difference between an error vector magnitude of the first signal and an error vector magnitude of the second signal is less than or equal to a first threshold.
A value of the first threshold may be determined with reference to factors such as a signal modulation scheme and a channel state of the second apparatus.
2. A signal to interference plus noise ratio of the performance indicator of the second signal is less than a second threshold. A value of the second threshold may be determined with reference to factors such as a signal modulation scheme and a channel state of the second apparatus.
3. A value of at least one coefficient in the first coefficient information exceeds a quantized bit width. The quantized bit width is a quantity of bits included when a coefficient is quantized and represented by using bits. The quantized bit width may be specified in a communication protocol, or may be configured by the second communication apparatus for the first communication apparatus. This is not specifically limited in this application.

Specifically, the first communication apparatus quantizes each coefficient in the first coefficient information, and then reports a quantized coefficient. For example, each coefficient is represented by using five bits, that is, the quantization bit width is five bits. In other words, each coefficient in the first coefficient information needs to be less than or equal to 31. When a coefficient is greater than 31, the first communication apparatus cannot quantize the coefficient. Therefore, the first communication apparatus may determine that the performance indicator of the second signal is abnormal.

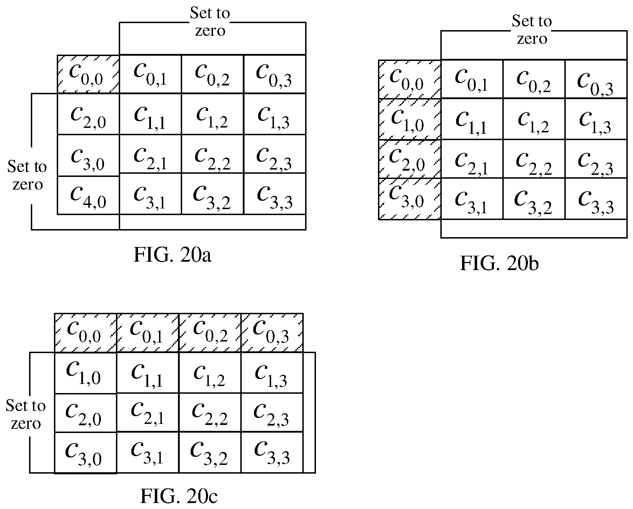

In a possible implementation, the first coefficient information includes the information about the DPD coefficient. The following describes some possible implementations of several possible first coefficient information reporting formats by using an example in which k is equal to 3 and m is equal to 3 in a memory polynomial model. Specifically, FIG. 20a to FIG. 20c show three possible first coefficient information reporting formats. $c_{km}$ represents a DPD coefficient corresponding to a nonlinear order k and a memory depth m.

As shown in FIG. 20a, the first communication apparatus reports $[c_{1,0}, 0,0,0,0,...]$ to the second communication apparatus. That is, the first communication apparatus reports one DPD coefficient, and other DPD coefficients are set to zero. As shown in FIG. 20b, the first communication apparatus reports all DPD coefficients of a memory depth 0 to the second communication apparatus, and other DPD coefficients are set to zero. As shown in FIG. 20c, the first communication apparatus reports, to the second communication apparatus, all DPD coefficients of nonlinear strength 1, and other DPD coefficients are set to zero.

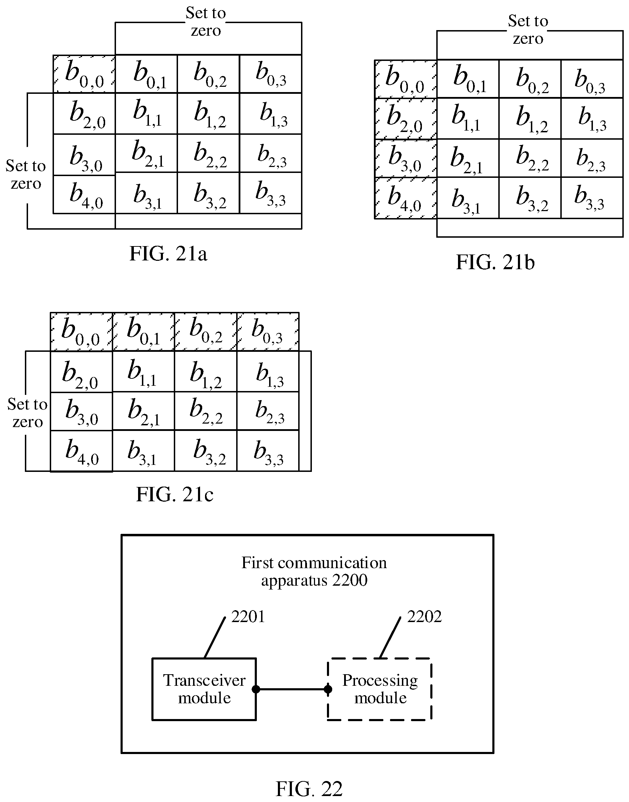

In another possible implementation, the first coefficient information includes the information about the equivalent PA coefficient. The following describes some possible implementations of several possible first coefficient information reporting formats by using an example in which k is equal to 3 and m is equal to 3 in a memory polynomial model. Specifically, FIG. 21a to FIG. 21c show three possible first coefficient information reporting formats. $b_{km}$ represents an equivalent PA coefficient corresponding to a nonlinear order k and a memory depth m.

As shown in FIG. 21a, the first communication apparatus reports $[b_{1,0}, 0,0,0,0, ...]$ to the second communication apparatus. That is, the first communication apparatus reports one equivalent PA coefficient, and other equivalent PA coefficients are set to zero. As shown in FIG. 21b, the first communication apparatus reports all equivalent PA coefficients of a memory depth 0 to the second communication apparatus, and other equivalent PA coefficients are set to zero. As shown in FIG. 21c, the first communication apparatus reports, to the second communication apparatus, all equivalent PA coefficients of nonlinear strength 1, and other equivalent PA coefficients are set to zero.

It should be noted that, optionally, the first coefficient information reporting format may be agreed on in a communications protocol, or may be indicated by the second communication apparatus to the first communication apparatus. This is not specifically limited in this application.

Optionally, the embodiment shown in FIG. 17 further includes step 1704b, and step 1704b may be performed after step 1703.

1704b: The first communication apparatus sends, to the second communication apparatus, first time-frequency resource information associated with the first performance indicator information. Correspondingly, the second communication apparatus receives, from the first communication apparatus, the first time-frequency resource information associated with the first performance indicator information.

The first time-frequency resource information includes location information of a first time-frequency resource used by the first communication apparatus to receive the first signal. The first performance indicator information is determined by the first communication apparatus based on the first signal received by the first communication apparatus on the first time-frequency resource.

Optionally, there is no fixed execution sequence between step 1704b, step 1704, and step 1704a. Specifically, an execution sequence of step 1704, step 1704a, and step 1704b is not limited in this application. For example, step 1704 may be performed first, then step 1704a is performed, and finally step 1704b is performed. Alternatively, step 1704a is performed first, then step 1704 is performed, and finally step 1704b is performed. Alternatively, step 1704b is performed first, then step 1704a is performed, and finally step 1704 is performed; or step 1704b, step 1704, and step 1704a are simultaneously performed according to a situation.

Optionally, the embodiment shown in FIG. 17 further includes step 1701b, and step 1701b may be performed before step 1701.

1701b: The second communication apparatus sends indication information to the first communication apparatus. Correspondingly, the first communication apparatus receives the indication information from the second communication apparatus.

The indication information indicates location information of a time-frequency resource used by the second communication apparatus to send the first signal. In this way, the first communication apparatus can receive the first signal on the time-frequency resource.

It should be noted that there is no fixed execution sequence between step 1701b and step 1703a. Step 1701b may be performed before step 1703a; or step 1703a is performed before step 1701b; or step 1701b and step 1703a are simultaneously performed according to a situation. This is not specifically limited in this application.

Optionally, the embodiment shown in FIG. 17 further includes step 1701c, and step 1701c may be performed before step 1701.

1701c: The second communication apparatus sends second configuration information to the first communication apparatus. Correspondingly, the first communication apparatus receives the second configuration information from the second communication apparatus.

The second configuration information includes information about a first resource. For the first resource, refer to the related descriptions of step 1001i in the embodiment shown in FIG. 10. Details are not described herein again.

Optionally, the embodiment shown in FIG. 17 further includes step 1701d, and step 1701d may be performed before step 1701.

1701d: The second communication apparatus sends third configuration information to the first communication apparatus. Correspondingly, the first communication apparatus receives the third configuration information from the second communication apparatus.

Step 1701a is similar to step 1001j in the embodiment shown in FIG. 10. For details, refer to the related descriptions of step 1001j in the embodiment shown in FIG. 10.

It should be noted that there is no fixed execution sequence between step 1701b to step 1701d and step 1703a. Specifically, an execution sequence of step 1701b to step 1701d and step 1703a is not limited in this application. For example, step 1701b to step 1701d may be performed before step 1703a; or step 1703a is performed before step 1701b to step 1701d; or step 1701b to step 1701d and step 1703a are simultaneously performed according to a situation.

The embodiment shown in FIG. 17 describes that the first communication apparatus and the second communication apparatus determine the first performance indicator information corresponding to the first digital channel. During actual application, determining of performance indicator information corresponding to another digital channel is also applicable, and details are not described herein. It should be noted that different digital channels may use different measurement resources, so as to avoid mutual interference between different digital channels or different beam directions when the first communication apparatus trains information about DPD coefficients corresponding to different digital channels, thereby improving DPD training performance.

The following describes the first communication apparatus provided in embodiments of this application. FIG. 22 is a diagram of a structure of a first communication apparatus according to an embodiment of this application. The first communication apparatus may be configured to perform the steps performed by the first communication apparatus in the embodiments shown in FIG. 10 and FIG. 17. For details, refer to the related descriptions in the foregoing method embodiments.

The first communication apparatus 2200 includes a transceiver module 2201. Optionally, the first communication apparatus 2200 further includes a processing module 2202.

The transceiver module 2201 may implement a corresponding communication function. The transceiver module 2201 may also be referred to as a communication interface or a communication unit. The processing module 2202 is configured to perform a processing operation.

Optionally, the first communication apparatus 2200 may further include a storage module. The storage module may be configured to store instructions and/or data. The processing module 2202 may read the instructions and/or the data in the storage module, so that the communication apparatus implements the method embodiments shown in FIG. 10 and FIG. 17.

The first communication apparatus 2200 may be configured to perform actions performed by the first communication apparatus in the foregoing method embodiments. The first communication apparatus 2200 may be a first communication apparatus or a component that may be disposed in the first communication apparatus. The transceiver module 2201 is configured to perform a receiving-related operation on the first communication apparatus side in the foregoing method embodiments, and the processing module 2202 is configured to perform a processing-related operation on the first communication apparatus side in the foregoing method embodiments.

Optionally, the transceiver module 2201 may include a sending module and a receiving module. The sending module is configured to perform a sending operation of the first communication apparatus in the method embodiments shown in FIG. 10 and FIG. 17. The receiving module is configured to perform a receiving operation of the first communication apparatus in the method embodiments shown in FIG. 10 and FIG. 17.

It should be noted that the first communication apparatus 2200 may include the sending module but not include the receiving module. Alternatively, the first communication apparatus 2200 may include the receiving module but not include the sending module. This may be specifically determined depending on whether the foregoing solution performed by the first communication apparatus 2200 includes a sending action and a receiving action.

Optionally, the first communication apparatus 2200 may be configured to perform the following solution:

The transceiver module 2201 is configured to receive a first signal from a second communication apparatus, where the first signal is a signal obtained by performing nonlinear compensation based on first coefficient information. The transceiver module 2201 is further configured to send first performance indicator information to the second communication apparatus, where the first performance indicator information is determined based on a performance indicator of the first signal.

The first communication apparatus 2200 may be configured to perform some or all steps performed by the first communication apparatus in the method embodiment shown in FIG. 10. For details, refer to the related descriptions of the embodiment shown in FIG. 10.

For example, the first communication apparatus 2200 may be configured to perform the following solution: The transceiver module 2201 is configured to receive a first signal from a second communication apparatus. The processing module 2202 is configured to: perform nonlinear compensation on the first signal based on first coefficient information, to obtain a second signal; and determine a performance indicator of the second signal. The transceiver module 2201 is further configured to send first performance indicator information to the second communication apparatus, where the first performance indicator information is determined based on the performance indicator of the second signal.

The first communication apparatus 2200 may be configured to perform some or all steps performed by the first communication apparatus in the method embodiment shown in FIG. 17. For details, refer to the related descriptions of the embodiment shown in FIG. 17.

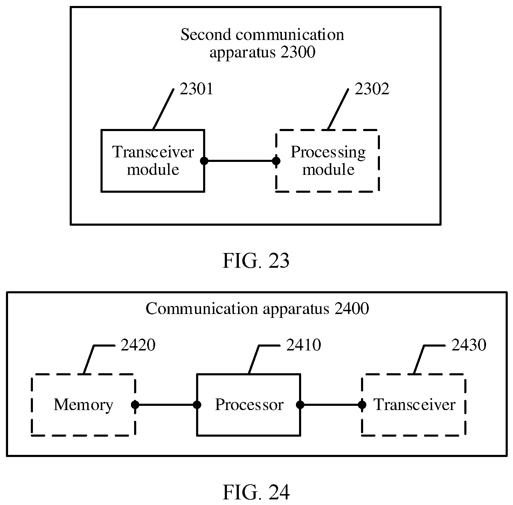

The following describes the second communication apparatus provided in embodiments of this application. FIG. 23 is a diagram of a structure of a second communication apparatus according to an embodiment of this application. The second communication apparatus may be configured to perform the steps performed by the second communication apparatus in the embodiments shown in FIG. 10 and FIG. 17. For details, refer to the related descriptions in the foregoing method embodiments.

The second communication apparatus 2300 includes a transceiver module 2301. Optionally, the second communication apparatus 2300 further includes a processing module 2302.

The transceiver module 2301 may implement a corresponding communication function. The transceiver module 2301 may also be referred to as a communication interface or a communication unit. The processing module 2302 is configured to perform a processing operation.

Optionally, the second communication apparatus 2300 may further include a storage module. The storage module may be configured to store instructions and/or data. The processing module 2302 may read the instructions and/or the data in the storage module, so that the communication apparatus implements the method embodiments shown in FIG. 10 and FIG. 17.

The second communication apparatus 2300 may be configured to perform actions performed by the second communication apparatus in the foregoing method embodiments. The second communication apparatus 2300 may be a second communication apparatus or a component that may be disposed in the second communication apparatus. The transceiver module 2301 is configured to perform a receiving-related operation on the second communication apparatus side in the foregoing method embodiments, and the processing module 2302 is configured to perform a processing-related operation on the second communication apparatus side in the foregoing method embodiments.

Optionally, the transceiver module 2301 may include a sending module and a receiving module. The sending module is configured to perform a sending operation of the second communication apparatus in the method embodiments shown in FIG. 10 and FIG. 17. The receiving module is configured to perform a receiving operation of the second communication apparatus in the method embodiments shown in FIG. 10 and FIG. 17.

It should be noted that the second communication apparatus 2300 may include the sending module but not include the receiving module. Alternatively, the second communication apparatus 2300 may include the receiving module but not include the sending module. This may be specifically determined depending on whether the foregoing solution performed by the second communication apparatus 2300 includes a sending action and a receiving action.

For example, the second communication apparatus 2300 may be configured to perform the following solution:

The transceiver module 2301 is configured to: send a first signal to a first communication apparatus, where the first signal is a signal obtained by performing nonlinear compensation based on first coefficient information; and receive first performance indicator information from the first communication apparatus, where the first performance indicator information is determined based on a performance indicator of the first signal.

The second communication apparatus 2300 may be configured to perform some or all steps performed by the second communication apparatus in the method embodiment shown in FIG. 10. For details, refer to the related descriptions of the embodiment shown in FIG. 10.

For example, the second communication apparatus 2300 may be configured to perform the following solution: The transceiver module 2301 is configured to: send a first signal to a first communication apparatus; and receive first performance indicator information from the first communication apparatus, where the first performance indicator information is determined based on a performance indicator of a second signal, and the second signal is obtained by the first communication apparatus by performing nonlinear compensation on the first signal based on first coefficient information.

The second communication apparatus 2300 may be configured to perform some or all steps performed by the second communication apparatus in the method embodiment shown in FIG. 17. For details, refer to the related descriptions of the embodiment shown in FIG. 17.

It should be understood that specific processes in which the modules perform the foregoing corresponding steps are described in detail in the foregoing method embodiments. For brevity, details are not described herein again.

The processing module 2302 in the foregoing embodiment may be implemented by at least one processor or processor-related circuit. The transceiver module 2301 may be implemented by a transceiver or a transceiver-related circuit. The transceiver module 2301 may also be referred to as a communication unit or a communication interface. The storage unit may be implemented by at least one storage.

An embodiment of this application further provides a communication apparatus 2400. The apparatus 2400 includes a processor 2410. The processor 2410 is coupled to a memory 2420. The memory 2420 is configured to store a computer program or instructions and/or data. The processor 2410 is configured to execute the computer program or the instructions and/or the data stored in the memory 2420, so that the method in the foregoing method embodiments is performed.

Optionally, the communication apparatus 2400 includes one or more processors 2410.

Optionally, as shown in FIG. 24, the communication apparatus 2400 may further include the memory 2420.

Optionally, the communication apparatus 2400 may include one or more memories 2420.

Optionally, the memory 2420 may be integrated with the processor 2410, or may be disposed separately from the processor 2410.

Optionally, as shown in FIG. 24, the communication apparatus 2400 may further include a transceiver 2430. The transceiver 2430 is configured to receive and/or send a signal. For example, the processor 2410 is configured to control the transceiver 2430 to receive and/or send a signal.

In a solution, the communication apparatus 2400 is configured to implement operations performed by the first communication apparatus in the foregoing method embodiments.

For example, the processor 2410 is configured to implement a processing-related operation performed by the first communication apparatus in the foregoing method embodiments, and the transceiver 2430 is configured to implement a receiving/sending-related operation performed by the first communication apparatus in the foregoing method embodiments.

In another solution, the communication apparatus 2400 is configured to implement operations performed by the second communication apparatus in the foregoing method embodiments.

For example, the processor 2410 is configured to implement a processing-related operation performed by the second communication apparatus in the foregoing method embodiments, and the transceiver 2430 is configured to implement a receiving/sending-related operation performed by the second communication apparatus in the foregoing method embodiments.

It should be noted that the transceiver 2403 may include a sending function but not include a receiving function. Alternatively, the transceiver 2403 may include a receiving function but not include a sending function. This may be specifically determined depending on whether the foregoing solution performed by the communication apparatus 2400 includes a sending action and a receiving action.

An embodiment of this application further provides a communication apparatus 2500. The communication apparatus 2500 may be a first communication apparatus, or may be a chip. The communication apparatus 2500 may be configured to perform operations performed by the first communication apparatus in the foregoing method embodiments.

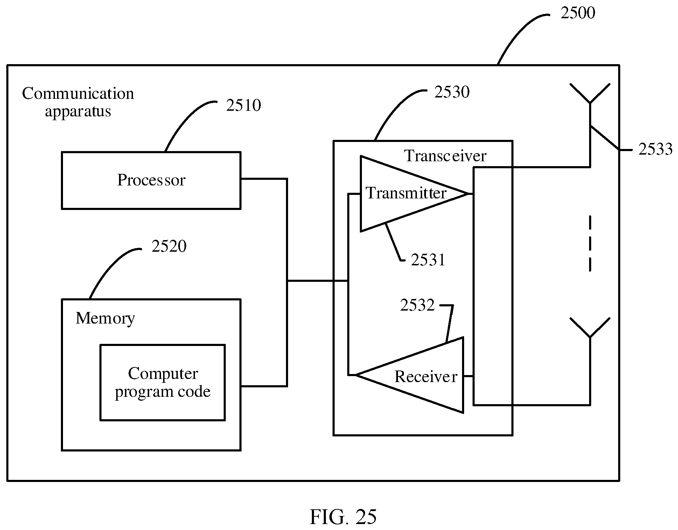

When the communication apparatus 2500 is a terminal device, FIG. 25 is a simplified diagram of a structure of the terminal device. As shown in FIG. 25, the terminal device includes a processor, a memory, and a transceiver. The memory may store computer program code. The transceiver includes a transmitter machine 2531, a receiver machine 2532, a radio frequency circuit (not shown), an antenna 2533, and an input/output apparatus (not shown).

The processor is mainly configured to: process a communications protocol and communications data, control the terminal device, execute a software program, process data of the software program, and the like. The memory is mainly configured to store the software program and data. The radio frequency circuit is mainly configured to: perform conversion between a baseband signal and a radio frequency signal, and process the radio frequency signal. The antenna is mainly configured to receive and send a radio frequency signal in a form of an electromagnetic wave. The input/output apparatus, such as a touchscreen, a display, or a keyboard, is mainly configured to receive data input by a user and output data to the user. It should be noted that some types of terminal devices may have no input/output apparatus.

When needing to send data, after performing baseband processing on the to-be-transmitted data, the processor outputs a baseband signal to the radio frequency circuit; and the radio frequency circuit performs radio frequency processing on the baseband signal and then sends the radio frequency signal to the outside in a form of an electromagnetic wave through the antenna. When data is sent to the terminal device, the radio frequency circuit receives the radio frequency signal through the antenna, converts the radio frequency signal into a baseband signal, and outputs the baseband signal to the processor. The processor converts the baseband signal into data, and processes the data. For ease of description, FIG. 25 shows only one memory, one processor, and one transceiver. In an actual terminal device product, there may be one or more processors and one or more memories. The memory may also be referred to as a storage medium, a storage device, or the like. The memory may be disposed independent of the processor, or may be integrated with the processor. This is not limited in embodiments of this application.

In embodiments of this application, the antenna and the radio frequency circuit that have a transceiver function may be considered as a transceiver unit of the terminal device, and the processor that has a processing function may be considered as a processing unit of the terminal device.

As shown in FIG. 25, the terminal device includes a processor 2510, a memory 2520, and a transceiver 2530. The processor 2510 may also be referred to as a processing unit, a processing board, a processing module, a processing apparatus, or the like, and the transceiver 2530 may also be referred to as a transceiver unit, a transceiver machine, a transceiver apparatus, or the like.

Optionally, a component configured to implement a receiving function in the transceiver 2530 may be considered as a receiving unit, and a component configured to implement a sending function in the transceiver 2530 may be considered as a sending unit. In other words, the transceiver 2530 includes a receiver and a transmitter. The transceiver sometimes may also be referred to as a transceiver machine, a transceiver unit, a transceiver circuit, or the like. The receiver sometimes may also be referred to as a receiver machine, a receiving unit, a receiving circuit, or the like. The transmitter sometimes may also be referred to as a transmitter machine, a transmitting unit, a transmitting circuit, or the like.

For example, in an implementation, the processor 2510 is configured to perform processing actions on the first communication apparatus side in the embodiments shown in FIG. 10 and FIG. 17, and the transceiver 2530 is configured to perform receiving and sending actions on the first communication apparatus side in the embodiments shown in FIG. 10 and FIG. 17.

It should be understood that FIG. 25 is merely an example instead of a limitation. The terminal device including the transceiver unit and the processing unit may not depend on the structure shown in FIG. 25.

When the communication apparatus 2500 is a chip, the chip includes a processor and a transceiver. The transceiver may be an input/output circuit or a communication interface. The processor may be a processing unit, a microprocessor, or an integrated circuit integrated on the chip. A sending operation performed by the terminal device in the foregoing method embodiments may be understood as an output of the chip, and a receiving operation performed by the terminal device in the foregoing method embodiments may be understood as an input of the chip.

An embodiment of this application further provides a communication apparatus 2600. The communication apparatus 2600 may be a second communication apparatus, or may be a chip. The communication apparatus 2600 may be configured to perform operations performed by the second communication apparatus in the foregoing method embodiments.

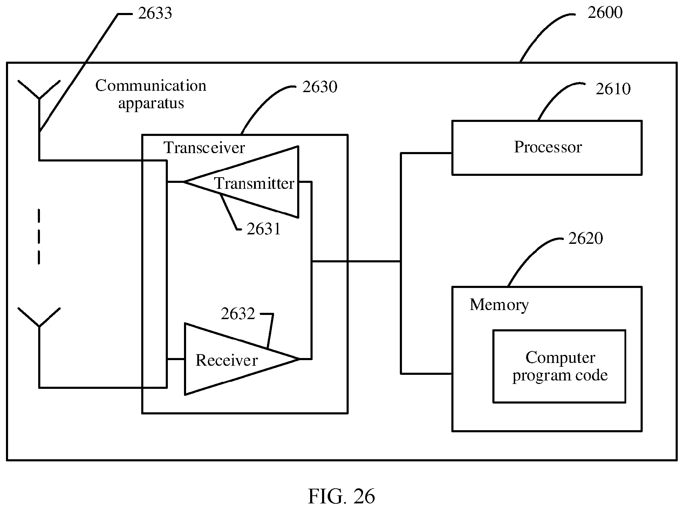

When the communication apparatus 2600 is a network device, for example, a base station, FIG. 26 is a simplified diagram of a structure of a base station. The base station includes a part 2610, a part 2620, and a part 2630.

The part 2610 is mainly configured to perform baseband processing, control the base station, and the like. The part 2610 is usually a control center of the base station, may be usually referred to as a processor, and is configured to control the base station to perform a processing operation on the network device side in the foregoing method embodiments. The part 2620 is mainly configured to store computer program code and data.

The part 2630 is mainly configured to: send and receive a radio frequency signal, and perform conversion between the radio frequency signal and a baseband signal.

The part 2630 may be usually referred to as a transceiver unit, a transceiver machine, a transceiver circuit, a transceiver, or the like. The transceiver unit in the part 2630 may also be referred to as a transceiver machine, a transceiver, or the like, and includes an antenna 2633 and a radio frequency circuit (not shown). The radio frequency circuit is mainly configured to perform radio frequency processing.

Optionally, a component configured to implement a receiving function in the part 2630 may be considered as a receiver machine, and a component configured to implement a sending function in the part 2630 may be considered as a transmitter machine. In other words, the part 2630 includes a receiver machine 2632 and a transmitter machine 2631. The receiver machine may also be referred to as a receiving unit, a receiver, a receiving circuit, or the like, and the transmitter machine may be referred to as a transmitting unit, a transmitter, a transmitting circuit, or the like.

The part 2610 and the part 2620 may include one or more boards, and each board may include one or more processors and one or more memories. The processor is configured to read and execute a program in the memory, to implement a baseband processing function and control the base station. If there are a plurality of boards, the boards may be interconnected with each other to enhance a processing capability. In an optional implementation, the plurality of boards may share one or more processors, or the plurality of boards share one or more memories, or the plurality of boards share one or more processors at the same time.

For example, in an implementation, the transceiver unit in the part 2630 is configured to perform receiving/sending-related steps performed by the second communication apparatus in the embodiments shown in FIG. 10 and FIG. 17. The processor in the part 2610 is configured to perform processing-related steps performed by the network device in the embodiments shown in FIG. 10 and FIG. 17.

It should be understood that FIG. 26 is merely an example rather than a limitation, and the network device including the processor, the memory, and the transceiver may not depend on the structure shown in FIG. 26.

When the communication apparatus 2600 is a chip, the chip includes a transceiver and a processor. The transceiver may be an input/output circuit or a communication interface. The processor is a processor, a microprocessor, or an integrated circuit integrated on the chip. A sending operation performed by the network device in the foregoing method embodiments may be understood as an output of the chip, and a receiving operation performed by the network device in the foregoing method embodiments may be understood as an input of the chip.

An embodiment of this application further provides a communication system, and the communication system includes a first communication apparatus and a second communication apparatus. The first communication apparatus is configured to perform all or some steps performed by the first communication apparatus in the embodiments shown in FIG. 10 and FIG. 17. The second communication apparatus is configured to perform all or some steps performed by the second communication apparatus in the embodiments shown in FIG. 10 and FIG. 17.

An embodiment of this application further provides a computer program product including instructions. When the computer program product runs on a computer, the computer is enabled to perform the communication methods in the embodiments shown in FIG. 10 and FIG. 17.

An embodiment of this application further provides a computer-readable storage medium, including computer instructions. When the computer instructions are run on a computer, the computer is enabled to perform the communication methods in the embodiments shown in FIG. 10 and FIG. 17.

An embodiment of this application further provides a chip apparatus, including a processor, configured to connect to a memory and invoke a program stored in the memory, so that the processor performs the communication methods in the embodiments shown in FIG. 10 and FIG. 17.

The processor mentioned in any of the foregoing may be a general central processing unit, a microprocessor, an application-specific integrated circuit (application-specific integrated circuit, ASIC), or one or more of integrated circuits configured to control program execution of the communication methods in the embodiments shown in FIG. 10 and FIG. 17. The memory mentioned in any one of the foregoing may be a read-only memory (read-only memory, ROM), another type of static storage device that can store static information and instructions, a random access memory (random access memory, RAM), or the like.

It may be clearly understood by a person skilled in the art that, for the purpose of convenient and brief description, for a detailed working process of the foregoing system, apparatus, and unit, refer to a corresponding process in the foregoing method embodiments, and details are not described herein again.

In the several embodiments provided in this application, it should be understood that the disclosed system, apparatus, and method may be implemented in other manners. For example, the described apparatus embodiments are merely examples. For example, division into units is merely logical function division and may be other division during actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, or each of the units may exist alone physically, or two or more units are integrated into one unit. The integrated unit may be implemented in a form of hardware, or may be implemented in a form of a software functional unit.

When the integrated unit is implemented in the form of the software functional unit and sold or used as an independent product, the integrated unit may be stored in a computer-readable storage medium. Based on such an understanding, a part that essentially contributes to the technical solutions of this application or all or some of the technical solutions may be implemented in the form of a software product. The computer software product is stored in a storage medium, and includes several instructions for enabling a computer device (which may be a personal computer, a server, a network device, or the like) to perform all or some steps of the methods in embodiments of this application. The foregoing storage medium includes: any medium that can store program code, a USB flash drive, a removable hard disk, a read-only memory (read-only memory, ROM), a random access memory (random access memory, RAM), a magnetic disk, an optical disc, and the like.

In conclusion, the foregoing embodiments are merely intended for describing the technical solutions of this application, but not for limiting this application. Although this application is described in detail with reference to the foregoing embodiments, persons of ordinary skill in the art should understand that they may still make modifications to the technical solutions described in the foregoing embodiments or make equivalent replacements to some technical features thereof, without departing from the scope of the technical solutions of embodiments of this application.

**Claims**

1. A communication method, wherein the method comprises:

   receiving, by a first communication apparatus, a first signal from a second communication apparatus, wherein the first signal is a signal obtained by performing nonlinear compensation based on first coefficient information; and
   sending, by the first communication apparatus, first performance indicator information to the second communication apparatus, wherein the first performance indicator information is determined based on a performance indicator of the first signal.

2. A communication method, wherein the method comprises:

   sending, by a second communication apparatus, a first signal to a first communication apparatus, wherein the first signal is a signal obtained by performing nonlinear compensation based on first coefficient information; and
   receiving, by the second communication apparatus, first performance indicator information from the first communication apparatus, wherein the first performance indicator information is determined based on a performance indicator of the first signal.

3. The method according to claim 1 or 2, wherein the performance indicator of the first signal comprises at least one of the following: an error vector magnitude, a signal to interference plus noise ratio, a signal-to-noise ratio, a supportable modulation and coding scheme, a channel quality indicator, a supportable highest modulation order, a mean squared error, a normalized mean squared error, or an adjacent channel leakage ratio of the first signal.

4. The method according to any one of claims 1 to 3, wherein the first performance indicator information comprises the performance indicator of the first signal.

5. The method according to any one of claims 1 to 3, wherein the first performance indicator information is determined based on the performance indicator of the first signal and a performance indicator of a second signal, and the second signal is a signal that is received by the first communication apparatus from the second communication apparatus and on which nonlinear compensation is not performed.

6. The method according to claim 5, wherein the first performance indicator information comprises: the performance indicator of the first signal and the performance indicator of the second signal; or

   the first performance indicator information comprises: the performance indicator of the first signal and a variation between the performance indicator of the first signal and the performance indicator of the second signal; or
   the first performance indicator information comprises: the performance indicator of the second signal and a variation between the performance indicator of the first signal and the performance indicator of the second signal.

7. The method according to claim 6, wherein the variation between the performance indicator of the first signal and the performance indicator of the second signal comprises at least one of the following:
   a variation between the error vector magnitude of the first signal and an error vector magnitude of the second signal; a variation between the signal-to-noise ratio of the first signal and a signal-to-noise ratio of the second signal; a variation between the channel quality indicator of the first signal and a channel quality indicator of the second signal; a variation between the mean squared error of the first signal and a mean squared error of the second signal; or a variation between the normalized mean squared error of the first signal and a normalized mean squared error of the second signal.

8. The method according to any one of claims 5 to 7, wherein before the method, the method further comprises:

   receiving, by the first communication apparatus, indication information from the second communication apparatus; or
   sending, by the second communication apparatus, indication information to the first communication apparatus, wherein
   the indication information indicates time-frequency resource information of the first signal and time-frequency resource information of the second signal, the time-frequency resource information of the first signal comprises location information of a time-frequency resource used by the second communication apparatus to send the first signal, and the time-frequency resource information of the second signal comprises location information of a time-frequency resource used by the second communication apparatus to send the second signal.

9. The method according to any one of claims 5 to 8, wherein the method further comprises:

sending, by the first communication apparatus to the second communication apparatus, first time-frequency resource information associated with the first performance indicator information; or
receiving, by the second communication apparatus from the first communication apparatus, first time-frequency resource information associated with the first performance indicator information, wherein
the first time-frequency resource information comprises location information of a first time-frequency resource used by the first communication apparatus to receive the first signal, and the first performance indicator information is determined by the first communication apparatus based on the first signal received by the first communication apparatus on the first time-frequency resource.

10. The method according to claim 9, wherein the first time-frequency resource information further comprises location information of a second time-frequency resource used by the first communication apparatus to receive the second signal, and the first performance indicator information is determined by the first communication apparatus based on the first signal received by the first communication apparatus on the first time-frequency resource and the second signal received by the first communication apparatus on the second time-frequency resource.

11. The method according to any one of claims 1 and 3 to 10, wherein before the receiving, by a first communication apparatus, a first signal from a second communication apparatus, the method further comprises:

receiving, by the first communication apparatus, the second signal from the second communication apparatus, wherein the second signal is a signal on which nonlinear compensation is not performed; and
sending, by the first communication apparatus, the first coefficient information to the second communication apparatus, wherein the first coefficient information is determined based on the second signal.

12. The method according to any one of claims 2 to 10, wherein before the sending, by a second communication apparatus, a first signal to a first communication apparatus, the method further comprises:

sending, by the second communication apparatus, the second signal to the first communication apparatus, wherein the second signal is a signal on which nonlinear compensation is not performed; and
receiving, by the second communication apparatus, the first coefficient information from the first communication apparatus, wherein the first coefficient information is determined by the first communication apparatus based on the second signal.

13. The method according to any one of claims 2 to 10, wherein before the sending, by a second communication apparatus, a first signal to a first communication apparatus, the method further comprises:

sending, by the second communication apparatus, a third signal to a third communication apparatus, wherein the third signal is a signal on which nonlinear compensation is not performed; and
receiving, by the second communication apparatus, the first coefficient information from the third communication apparatus, wherein the first coefficient information is determined by the third communication apparatus based on the third signal.

14. The method according to any one of claims 1 and 3 to 11, wherein before the sending, by the first communication apparatus, first performance indicator information to the second communication apparatus, the method further comprises:

receiving, by the first communication apparatus, first configuration information sent by the second communication apparatus, wherein the first configuration information indicates the first communication apparatus to report a reporting configuration of the first performance indicator information; and
the sending, by the first communication apparatus, first performance indicator information to the second communication apparatus comprises:
sending, by the first communication apparatus, the first performance indicator information to the second communication apparatus based on the reporting configuration.

15. A communication method, wherein the method comprises:

receiving, by a first communication apparatus, a first signal from a second communication apparatus;

performing, by the first communication apparatus, nonlinear compensation on the first signal based on first coefficient information, to obtain a second signal; and

sending, by the first communication apparatus, first performance indicator information to the second communication apparatus, wherein the first performance indicator information is determined based on a performance indicator of the second signal.

16. A communication method, wherein the method comprises:

sending, by a second communication apparatus, a first signal to a first communication apparatus; and

receiving, by the second communication apparatus, first performance indicator information from the first communication apparatus, wherein the first performance indicator information is determined based on a performance indicator of the second signal, and the second signal is obtained by the first communication apparatus by performing nonlinear compensation on the first signal based on first coefficient information.

17. The method according to claim 15 or 16, wherein the performance indicator of the second signal comprises at least one of the following: an error vector magnitude, a signal to interference plus noise ratio, a signal-to-noise ratio, a supportable modulation and coding scheme, a channel quality indicator, a supportable highest modulation order, a mean squared error, a normalized mean squared error, or an adjacent channel leakage ratio of the second signal.

18. The method according to any one of claims 15 to 17, wherein the first performance indicator information comprises the performance indicator of the second signal.

19. The method according to any one of claims 15 to 17, wherein the first performance indicator information is determined based on a performance indicator of the first signal and the performance indicator of the second signal.

20. The method according to claim 19, wherein the first performance indicator information comprises: the performance indicator of the first signal and a performance indicator of the second signal; or

the first performance indicator information comprises: the performance indicator of the first signal and a variation between the performance indicator of the first signal and the performance indicator of the second signal; or

the first performance indicator information comprises: the performance indicator of the second signal and a variation between the performance indicator of the first signal and the performance indicator of the second signal.

21. The method according to claim 20, wherein the variation between the performance indicator of the first signal and the performance indicator of the second signal comprises at least one of the following: a variation between an error vector magnitude of the first signal and the error vector magnitude of the second signal; a variation between a signal-to-noise ratio of the first signal and the signal-to-noise ratio of the second signal; a variation between a channel quality indicator of the first signal and the channel quality indicator of the second signal; a variation between a mean squared error of the first signal and the mean squared error of the second signal; or a variation between a normalized mean squared error of the first signal and the normalized mean squared error of the second signal.

22. The method according to any one of claims 15 to 21, wherein before the method, the method further comprises:

receiving, by the first communication apparatus, indication information from the second communication apparatus; or

sending, by the second communication apparatus, indication information to the first communication apparatus, wherein

the indication information indicates location information of a time-frequency resource used by the second communication apparatus to send the first signal.

23. The method according to any one of claims 15 to 22, wherein the method further comprises:

sending, by the first communication apparatus, the first coefficient information to the second communication apparatus, wherein the first coefficient information is determined based on the first signal; or

receiving, by the second communication apparatus, the first coefficient information from the first communication apparatus.

24. The method according to claim 23, wherein the first coefficient information comprises information about a predistortion parameter or information about an equivalent power amplifier coefficient; and
the sending, by the first communication apparatus, the first configuration information to the second communication apparatus comprises:
when the performance indicator of the second signal is abnormal, sending, by the first communication apparatus, the first coefficient information to the second communication apparatus according to a first coefficient information reporting format, wherein the first coefficient information reporting format comprises a reporting requirement for a nonlinear order and a memory depth in the predistortion parameter or the equivalent power amplifier coefficient, and the first coefficient information reporting format indicates that the performance indicator of the second signal is abnormal.

25. The method according to any one of claims 15 to 24, wherein the method further comprises:

sending, by the first communication apparatus to the second communication apparatus, first time-frequency resource information associated with the first performance indicator information; or
sending, by the second communication apparatus to the first communication apparatus, first time-frequency resource information associated with the first performance indicator information, wherein
the first time-frequency resource information comprises location information of a first time-frequency resource used by the first communication apparatus to receive the first signal, and the first performance indicator information is determined by the first communication apparatus based on the first signal received by the first communication apparatus on the first time-frequency resource.

26. The method according to any one of claims 15 and 17 to 24, wherein before the sending, by the first communication apparatus, first performance indicator information to the second communication apparatus, the method further comprises:

receiving, by the first communication apparatus, first configuration information sent by the second communication apparatus, wherein the first configuration information indicates the first communication apparatus to report a reporting configuration of the first performance indicator information; and
the sending, by the first communication apparatus, first performance indicator information to the second communication apparatus comprises:
sending, by the first communication apparatus, the first performance indicator information to the second communication apparatus based on the reporting configuration.

27. A communication apparatus, wherein the communication apparatus comprises a transceiver module, wherein

the transceiver module is configured to perform the method according to any one of claims 1, 3 to 11, and 14;
the transceiver module is configured to perform the method according to any one of claims 2 to 10, 12, and 13;
the transceiver module is configured to perform the method according to any one of claims 15 and 17 to 26; or
the transceiver module is configured to perform the method according to any one of claims 16 to 23 and 25.

28. A communication apparatus, wherein the communication apparatus comprises a processor, and the processor is configured to execute a computer program or computer instructions in a memory, to perform the method according to any one of claims 1, 3 to 11, and 14, the method according to any one of claims 2 to 10, 12, and 13, the method according to any one of claims 15 and 17 to 26, or the method according to any one of claims 16 to 23 and 25.

29. A computer-readable storage medium, wherein the computer-readable storage medium stores a computer program, and when the computer program is executed by a communication apparatus, the communication apparatus is enabled to perform the method according to any one of claims 1 to 14 or the method according to any one of claims 15 to 26.

EP 4 590 014 A1

FIG. 1

FIG. 2

FIG. 3

FIG. 4a  FIG. 4b  FIG. 4c

Baseband signal → IFFT processing → Filter → Crest factor reduction CFR → Digital predistortion DPD processing → Digital-to-analog converter DAC

Digital channel 1

Signal before a PA

Phase shifter → PA

Digital channel n

FIG. 5

EP 4 590 014 A1

FIG. 6

FIG. 7

FIG. 8

FIG. 9

```
┌─────────────┐          ┌─────────────┐          ┌─────────────┐
│    Third    │          │    First    │          │   Second    │
│communication│          │communication│          │communication│
│  apparatus  │          │  apparatus  │          │  apparatus  │
└──────┬──────┘          └──────┬──────┘          └──────┬──────┘
```

1001i: Second configuration information

1001j: Third configuration information

1001h: Indication information
(indicating time-frequency resource
information of a first signal)

Manner 1

1001b: Second signal
(the second signal is a signal on which
nonlinear compensation is not
performed)

1001c: Determine first coefficient
information based on the second signal

1001d: First coefficient information

Manner 2

1001e: Third signal
(the third signal is a signal on which
nonlinear compensation is not
performed)

1001f: Determine first coefficient
information based on the third signal

1001g: First coefficient information

1001a: First configuration information
(indicating the first communication
apparatus to report a reporting
configuration of first performance
indicator information)

1001: First signal
(the first signal is a signal obtained by
performing nonlinear compensation
based on first coefficient information)

1002: Determine a performance
indicator of the first signal

1003: First performance indicator
information
(the first performance indicator
information is determined based on the
performance indicator of the first signal)

1004: First time-frequency resource
information associated with the first
performance indicator information

FIG. 10

g(.)

x(t) →
| Nonlinear compensation (also referred to as DPD processing) |

z(t) →

f(.)

Equivalent PA

y(t) →

FIG. 11A

u(n) →
| Nonlinear compensation (also referred to as DPD processing) |

z(n) →

Equivalent PA

r(n) →

FIG. 11B

EP 4 590 014 A1

Power

EVM

EVM
requirement

Transmit
power

Error vector
magnitude EVM

FIG. 12a

Power

EVM

EVM
requirement

Transmit
power

EVM

FIG. 12b

Power

EVM

EVM
requirement

Transmit
power

EVM

FIG. 12c

Power

EVM

EVM
requirement

Transmit
power

EVM

FIG. 12d

EP 4 590 014 A1

Digital
channel 1

┌─────────────┐        ┌──────┐
│  Digital    │ x[n]   │      │
│predistortion│───────▶│ DAC  │───────▶
│DPD processing│       │      │
└─────────────┘        └──────┘

Equivalent
PA

Beam beam

Process
processing

r(n)

Reconstruct a
signal before
a PA x(n)

Feed back a DPD coefficient

DPD
coefficient
estimation

FIG. 13A

FIG. 13B

FIG. 13C

FIG. 14A

FIG. 14B

Case 1 Period of a reference signal=5 slots, Offset=0

Case 2 Period of a reference signal=5 slots, Offset=3

Case 3 Period of a reference signal=10 slots, Offset=3

FIG. 14C

DPD model bandwidth

| 800 MHz | 800 MHz (megahertz) | 800 MHz |

983.04 MHz

Sampling bandwidth used by a
first communication apparatus

FIG. 15A

DPD model bandwidth

| 800 MHz | 800 MHz (megahertz) | 800 MHz |

983.04 MHz   983.04 MHz

Sampling bandwidth used by a
first communication apparatus

FIG. 15B

| $c_{0,0}$ | $c_{0,1}$ | $c_{0,2}$ | $c_{0,3}$ |
|---|---|---|---|
| $c_{1,0}$ | $c_{1,1}$ | $c_{1,2}$ | $c_{1,3}$ |
| $c_{2,0}$ | $c_{2,1}$ | $c_{2,2}$ | $c_{2,3}$ |
| $c_{3,0}$ | $c_{3,1}$ | $c_{3,2}$ | $c_{3,3}$ |

FIG. 16a

| $c_{0,0}$ | $c_{0,1}$ | $c_{0,2}$ | $c_{0,3}$ |
|---|---|---|---|
| $c_{1,0}$ | $c_{1,1}$ | $c_{1,2}$ | $c_{1,3}$ |
| $c_{2,0}$ | $c_{2,1}$ | $c_{2,2}$ | $c_{2,3}$ |
| $c_{3,0}$ | $c_{3,1}$ | $c_{3,2}$ | $c_{3,3}$ |

FIG. 16b

| $c_{0,0}$ | $c_{0,1}$ | $c_{0,2}$ | $c_{0,3}$ |
|---|---|---|---|
| $c_{1,0}$ | $c_{1,1}$ | $c_{1,2}$ | $c_{1,3}$ |
| $c_{2,0}$ | $c_{2,1}$ | $c_{2,2}$ | $c_{2,3}$ |
| $c_{3,0}$ | $c_{3,1}$ | $c_{3,2}$ | $c_{3,3}$ |

FIG. 16c

| $c_{0,0}$ | $c_{0,1}$ | $c_{0,2}$ | $c_{0,3}$ |
|---|---|---|---|
| $c_{1,0}$ | $c_{1,1}$ | $c_{1,2}$ | $c_{1,3}$ |
| $c_{2,0}$ | $c_{2,1}$ | $c_{2,2}$ | $c_{2,3}$ |
| $c_{3,0}$ | $c_{3,1}$ | $c_{3,2}$ | $c_{3,3}$ |

FIG. 16d

```
┌──────────────┐                                    ┌──────────────┐
│    First     │                                    │    Second    │
│ communication│                                    │ communication│
│   apparatus  │                                    │   apparatus  │
└──────────────┘                                    └──────────────┘
```

1701c: Second configuration information

1701d: Third configuration information

1701b: Indication information

1701: First signal

1701a: Determine first coefficient information based on the first signal

1702: Perform nonlinear compensation on the first signal based on the first coefficient information, to obtain a second signal

1703: Determine a performance indicator of the second signal

1703a: First configuration information
(indicating the first communication apparatus to report a reporting configuration of first performance indicator information）

1704: First performance indicator information
(the first performance indicator information is determined based on the performance indicator of the second signal)

1704a: First coefficient information

1704b: First time-frequency resource information associated with the first performance indicator information

FIG. 17

FIG. 18

Case 1

| Obtain first coefficient information and first performance indicator information | | Report the first coefficient information and the first performance indicator information |
|---|---|---|

First resource · Second resource · Resource

Case 2

| Obtain first coefficient information | Obtain first performance indicator information | Report the first coefficient information and the first performance indicator information |
|---|---|---|

Second resource · First resource · Third resource · Resource

Case 3

| Obtain first coefficient information | Report the first coefficient information | Obtain first performance indicator information | Report the first performance indicator information |
|---|---|---|---|

Second resource · Third resource · First resource · Fourth resource · Resource

FIG. 19

Set to zero

| $c_{0,0}$ | $c_{0,1}$ | $c_{0,2}$ | $c_{0,3}$ |
|---|---|---|---|
| $c_{2,0}$ | $c_{1,1}$ | $c_{1,2}$ | $c_{1,3}$ |
| $c_{3,0}$ | $c_{2,1}$ | $c_{2,2}$ | $c_{2,3}$ |
| $c_{4,0}$ | $c_{3,1}$ | $c_{3,2}$ | $c_{3,3}$ |

Set to zero

FIG. 20a

Set to zero

| $c_{0,0}$ | $c_{0,1}$ | $c_{0,2}$ | $c_{0,3}$ |
|---|---|---|---|
| $c_{1,0}$ | $c_{1,1}$ | $c_{1,2}$ | $c_{1,3}$ |
| $c_{2,0}$ | $c_{2,1}$ | $c_{2,2}$ | $c_{2,3}$ |
| $c_{3,0}$ | $c_{3,1}$ | $c_{3,2}$ | $c_{3,3}$ |

FIG. 20b

| $c_{0,0}$ | $c_{0,1}$ | $c_{0,2}$ | $c_{0,3}$ |
|---|---|---|---|
| $c_{1,0}$ | $c_{1,1}$ | $c_{1,2}$ | $c_{1,3}$ |
| $c_{2,0}$ | $c_{2,1}$ | $c_{2,2}$ | $c_{2,3}$ |
| $c_{3,0}$ | $c_{3,1}$ | $c_{3,2}$ | $c_{3,3}$ |

Set to zero

FIG. 20c

FIG. 21a

FIG. 21b

FIG. 21c

FIG. 22

Second communication
apparatus 2300

2301                              2302

Transceiver
module          Processing
module

FIG. 23

Communication apparatus 2400

2420            2410            2430

Memory          Processor          Transceiver

FIG. 24

FIG. 25

FIG. 26

## INTERNATIONAL SEARCH REPORT

International application No.

**PCT/CN2023/129949**

| A. | CLASSIFICATION OF SUBJECT MATTER |
|---|---|

H04W 24/02(2009.01)i

According to International Patent Classification (IPC) or to both national classification and IPC

| B. | FIELDS SEARCHED |
|---|---|

Minimum documentation searched (classification system followed by classification symbols)

Documentation searched other than minimum documentation to the extent that such documents are included in the fields searched

IPC: H04L H04B H03F

Electronic data base consulted during the international search (name of data base and, where practicable, search terms used)

CNTXT, ENTXTC, WPABSC, ENTXT, WPABS, DWPI: 补偿, 参数, 第二, 第一, 调制编码, 放大器, 非线性, 非线性补偿, 幅度, 功率放大, 归一化, 均方误差, 设备, 误差, 系数, 向量, 泄露比, 信道质量, 信干噪比, 性能, 预失真, 指标, 装置, 最高 调制阶数, DPD, PA, compensation, parameter, second, first, modulat+, amplifier, non-linear, amplitude, power amplification, pre-distortion, indicator

| C. | DOCUMENTS CONSIDERED TO BE RELEVANT |
|---|---|

| Category* | Citation of document, with indication, where appropriate, of the relevant passages | Relevant to claim No. |
|---|---|---|
| X | RU 0002779459 C1 (LG ELECTRONICS INC.) 07 September 2022 (2022-09-07) description, paragraphs [0010]-[0023] and [0243]-[0298] | 1-29 |
| A | CN 107241070 A (DATANG MOBILE COMMUNICATIONS EQUIPMENT CO., LTD.) 10 October 2017 (2017-10-10) entire document | 1-29 |
| A | CN 111490737 A (CHINA MOBILE COMMUNICATION LTD., RESEARCH INSTITUTE et al.) 04 August 2020 (2020-08-04) entire document | 1-29 |
| A | CN 114665962 A (HUAWEI TECHNOLOGIES CO., LTD.) 24 June 2022 (2022-06-24) entire document | 1-29 |
| A | US 2017078027 A1 (FUJITSU LTD.) 16 March 2017 (2017-03-16) entire document | 1-29 |

☐ Further documents are listed in the continuation of Box C.     ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **11 January 2024** | **18 January 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

| International application No. |
| --- |
| **PCT/CN2023/129949** |

| Patent document cited in search report | | | Publication date (day/month/year) | Patent family member(s) | | | Publication date (day/month/year) |
| --- | --- | --- | --- | --- | --- | --- | --- |
| RU | 0002779459 | C1 | 07 September 2022 | None | | | |
| CN | 107241070 | A | 10 October 2017 | None | | | |
| CN | 111490737 | A | 04 August 2020 | None | | | |
| CN | 114665962 | A | 24 June 2022 | None | | | |
| US | 2017078027 | A1 | 16 March 2017 | JP | 2017059962 | A | 23 March 2017 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202211422272